Europäisches Patentamt

European Patent Office

Office européen des brevets

(19)

(11) **EP 0 791 180 B1**

(12) **EUROPÄISCHE PATENTSCHRIFT**

(45) Veröffentlichungstag und Bekanntmachung des Hinweises auf die Patenterteilung:
**15.10.2003 Patentblatt 2003/42**

(51) Int Cl.⁷: $G01S\ 13/02$, $H03H\ 9/145$, $H03H\ 9/64$

(21) Anmeldenummer: **95934801.2**

(22) Anmeldetag: **08.11.1995**

(86) Internationale Anmeldenummer:
**PCT/IB95/00982**

(87) Internationale Veröffentlichungsnummer:
**WO 96/014589 (17.05.1996 Gazette 1996/22)**

(54) **VERFAHREN ZUM BERÜHRUNGSLOSEN IDENTIFIZIEREN VON MOBILEN TRANSPONDERN**

MOBILE TRANSPONDER REMOTE IDENTIFICATION PROCESS

PROCEDE D'IDENTIFICATION A DISTANCE DE REPONDEURS MOBILES

(84) Benannte Vertragsstaaten:
**CH DE IT LI SE**

(30) Priorität: **08.11.1994 CH 333994**
**08.11.1994 CH 334094**

(43) Veröffentlichungstag der Anmeldung:
**27.08.1997 Patentblatt 1997/35**

(73) Patentinhaber: **HERA Rotterdam B.V.**
**3062 MA Rotterdam (NL)**

(72) Erfinder:
• **PLESSKY, Victor P.**
**CH-2206 Geneveys-sur-Coffrance (CH)**
• **KONDRATYEV, Sergei N.**
**CH-2000 Neuchâtel (CH)**

(74) Vertreter: **VOSSIUS & PARTNER**
**Siebertstrasse 4**
**81675 München (DE)**

(56) Entgegenhaltungen:
DE-A- 2 824 371      US-A- 4 048 594
US-A- 4 096 477      US-A- 4 309 679
US-A- 4 625 207      US-A- 4 734 698

EP 0 791 180 B1

## Beschreibung

### Technisches Gebiet

Die Erfindung betrifft ein Verfahren zum berührungslosen Identifizieren von mobilen Transpondern, wobei

a) eine Abfragestation ein Abfragesignal aussendet,

b) der Transponder das Abfragesignal entsprechend einem für ihn spezifischen Code in ein Antwortsignal umwandelt und

c) die Abfragestation das zurückgesendete Antwortsignal decodiert.

Ferner betrifft die Erfindung einen passiven Transponder mit einer SAW-Einheit zur Erzeugung von Antwortsignalen enthaltend einen identifizierbaren Code, wobei die SAW-Einheit mindestens einen Transducer zum Umwandeln elektrischer Signale in Oberflächenwellen und umgekehrt sowie mehrere Reflektoren aufweist.

### Stand der Technik

SAW-Elemente (SAW = surface acoustic wave) nutzen die niedrige Ausbreitungsgeschwindigkeit und die leichte Beeinflussbarkeit von Oberflächenwellen aus, um Signale sehr hoher Frequenzen in irgendeiner Weise zu verarbeiten. Bekannt und eingehend untersucht sind z. B. Filterstrukturen (wie z. B. Bandbreitenfilter, konjugierte Filter, Dispersionsfilter etc.), Resonatoren, Verzögerungslinien oder Spektralanalysatoren. Wenngleich die verschiedenen Anwendungen auf denselben physikalischen Grundprinzipien beruhen, unterscheiden sie sich hinsichtlich ihrer Ausführungsformen jedoch stark. So geht es beispielsweise bei den Filtern (reflective array compressor, RAC) darum, mit einer quasi periodischen Gitterstruktur, mit einer sehr hohen Anzahl von schwach reflektierenden Gitterelementen (in der Regel eingeätzten Gräben) die Charakteristik eines eintreffenden Signals zu verändern. Es ist dabei wichtig, dass eine hohe Anzahl (typischerweise mehrere Hundert) Gitterelemente mit vorgebbarer (resp. gewichteter) Reflektivität vorhanden sind.

Bei Verzögerungsgliedern kommt es im Gegensatz zu Filteranwendungen auf die Erzeugung verzögerter Signale bei möglichst geringer Dämpfung an.

Eine Uebersicht über die Implementation von SAW-Elementen gibt der Artikel "Propagation of acoustic surface waves in periodic structures", YU.V. Guliaev und V.P. Plesskii, Sov. Phys. Usp. 32(1), Januar 1989 (veröffentlicht in Englisch durch American Institute of Physics, 1989, Seiten 51-74).

Seit einiger Zeit wird auch versucht, SAW-Elemente als Transponder resp. tag für berührungslose Abfragesysteme zu nutzen. Die Grundidee ist dabei die, dass ein passiver Transponder auf ein Abfragesignal mit einem Antwortsignal reagiert, das einen Code enthält, der die Identifikation des Transponders resp. tags ermöglicht.

Ein Verfahren der eingangs genannten Art ist z. B. aus dem US-Patent 4,737,790 (Skele et al./X-Cyte, Inc.) bekannt. Mit einer Abfragestation können dabei sog. tags mit passiven Transpondern identifiziert werden. Die Transponder werden durch ein SAW-Element aus piezoelektrischem Material gebildet, die über geeignete Antennen zum Empfangen und Abstrahlen von elektromagnetischen Wellen im Bereich von 905-925 MHz verfügen. Das SAW-Element modifiziert das empfangene Abfragesignal in Amplitude und Phase. Das Abfragesignal ist ein sog. chirp-Signal, dessen Frequenz sägezahnartig im Bereich von 905-925 MHz variiert. Das SAW-Element verfügt über 16 verschiedene Ausbreitungspfade. Ihre Signallaufzeiten sind für alle SAW-Elemente des Systems so festgelegt, dass sie sich jeweils um ein vorgegebenes Zeitintervall DeltaT unterscheiden. Die über verschiedene Pfade laufenden Signale weisen somit eine konstante (d. h. für alle tags gleiche) zeitliche Stufung auf. Beim Mischen des Abfragesignals mit den Antwortsignalen wird in der Abfragestation eine vorgegebene Anzahl von im voraus bekannten Differenzfrequenzen erzeugt. Die Differenzfrequenzen entsprechen den Schwebungen zwischen dem Abfrage- und den Antwortsignalen. Sie werden von entsprechend abgestimmten Filtern verarbeitet. Da im SAW-Element jedem Ausbreitungspfad Dämpfungs- bzw. Phasenschiebeelemente entsprechend dem transponderspezifischen Code eingebaut sind, lassen sich aus den Phasen bzw. Amplituden der Differenzfrequenzen die transponderspezifischen Codeinformationen gewinnen.

Die in der US-Patentschrift 4,737,790 beschriebene SAW-Einheit verfügt über einen SAW-Chip mit vier in der Mitte positionierten, jedoch leicht gegeneinander versetzt angeordneten Transducern (zum Umsetzen der elektrischen Wellen in Oberflächenwellen und umgekehrt). Beidseits jedes Transducers sind zwei Reflektoren vorgesehen. Vor den Reflektoren sind jeweils phasendrehende Elemente angeordnet, die eine codespezifische Phasendrehung erzeugen. Da in jedem Kanal zwei Reflektoren und zwei Phasendrehglieder angeordnet sind, wird das Reflexions-Signal des äusseren Reflektors immer auch vom Phasendrehglied des inneren Reflektors beeinflusst. Dies erschwert das Chipdesign beträchtlich. Zudem treten vermehrt Störsignale auf.

US-A-4 734 698 beschreibt ein System zum berührungslosen Identifizieren von passiven Transpondern, wobei eine Abfragestation ein chirpförmiges Abfragesignal aussendet, der Transponder nach einem für ihn spezifischen Code ein Antwortsignal mit mehreren unterschiedlich und codespezifisch phasenverschobenen Signalkomponenten bildet und die Abfragestation das Antwortsignal decodiert. Die Zahl der Signalkomponenten ist dabei für alle Transponder des Systems gleich, und der Code besteht in einer spezifisch definierten Verzögerung der einzelnen Signalkomponenten.

Die Erzeugung von chirp-Signalen und die entsprechende Signaldecodierung stellen sehr hohe Anforderungen an die Signalgenauigkeit. So müssen z. B. die einzelnen chirp-Teile einen streng linearen Frequenzverlauf aufweisen mit absolut konstantem Frequenzanstieg und exakter chirp-Länge. Schon kleinste Abweichungen können zu Modulationen der Differenzfrequenzen führen, wodurch die Decodierung verunmöglicht werden kann.

Es zeigt sich, dass der erwähnte, bekannte Transponder nicht nur aufwendig im Chipdesign ist, sondern auch unterschiedlichste Störsignale hat. Auch herstellungsmässig bestehen Probleme: Technologische Defekte bei innenliegenden Phasendrehgliedern wirken sich zugleich auf zwei Signalausbreitungspfade aus. Schliesslich ist die Substratoberfläche relativ schlecht genutzt, was sich aufgrund der statistisch auftretenden Substratdefekte in entsprechend nachteiligen Ausschusszahlen niederschlägt.

Ein grosses Problem beim bekannten Transponder ist die Temperaturempfindlichkeit. Für einen Temperaturbereich von 100 °C und für ein Lithiumniobat-Substrat ergeben sich Laufzeitunterschiede von Delta tau = $94 \times 10^{-6}$ x 100 °C x 100 ns = 0.94 ns zwischen aufeinanderfolgenden Signalen. Bei einer Frequenz von 905 MHz entspricht dies einer Phase von ca. 1.7n. Die Phasenverschiebung zwischen dem ersten und dem letzten Antwortsignal ist zudem etwa 15 Mal grösser d. h. von der Grössenordnung von 25n. Bei höheren Frequenzen von z. B. 2.45 GHz ergeben sich entsprechend grössere temperaturbedingte Phasenverschiebungen. Die Decodierung der Phase muss dabei mit einer Genauigkeit von $\pm\pi/6$ erfolgen.

## Darstellung der Erfindung

Aufgabe der Erfindung ist es, ein Verfahren der eingangs genannten Art anzugeben, das eine einfachere und fehlertolerantere Decodierung zulässt.

Gemäss der Erfindung besteht die Lösung darin, dass der Code in einer spezifisch definierten zeitlichen Verzögerung von mindestens einer Signalkomponente des Antwortsignals liegt.

Anwortsignale von unterschiedlichen Transpondern unterscheiden sich somit durch unterschiedliche Verzögerungszeiten. Vorzugsweise weist ein Antwortsignal mehrere codespezifisch verzögerte Signalkomponenten auf. Die Zahl der individuell verzögerten Signalkomponenten ist für alle Transponder des Systems gleich. Unterscheidet sich die Zahl der gemessenen Signalkomponenten von der für das Signal vorgegebenen, dann weist dies auf einen Detektionsfehler hin. Zur Detektion eignet sich die als solche bekannte matched filter-Technik.

Vorzugsweise sind die Verzögerungszeiten so festgelegt, dass zum Decodieren des Antwortsignals jeder Signalkomponente ein vorgegebenes Zeitfenster mit einem vordefinierten Raster von Zeitschlitzen zugeordnet wird und dass die Decodierung durch-Bestimmen des Zeitschlitzes erfolgt, in welchen die Signalkomponente resp. ihr "Energieschwerpunkt" fällt. Die Verzögerungszeiten sind also für alle Transponder des Systems so festgelegt, dass in jedes der vordefinierten Zeitfenster genau eine Signalkomponente fällt. Die zeitliche Position der Signalkomponente im entsprechenden Zeitfenster stellt einen Teil der codierten Information dar.

Mit Vorteil beträgt die zeitliche Verzögerung der ersten Signalkomponente mindestens die Hälfte der zeitlichen Verzögerung der letzten Signalkomponente. Auf diese Weise können Störeinflüsse von sog. round trip-Signalen weitgehend eliminiert werden.

Gemäss einer bevorzugten Ausführungsform weist ein Zeitfenster höchstens zehn, vorzugsweise fünf bis sieben Zeitschlitze auf. Eine mässige Anzahl von Zeitschlitzen erleichtert nicht nur die Detektion resp. Decodierung, sondern reduziert auch die erforderliche Produktionsgenauigkeit der SAW-Einheiten. Bei 12 Zeitfenstern und 5-10 Zeitschlitzen lassen sich zwischen $5^{12}$ (= $2.44 \times 10^8$) bis $10^{12}$ unterschiedliche Codierungen durchführen.

Das Abfragesignal ist z. B. ein Puls einer Dauer von 5-10 ns und einer Frequenz von 1 GHz oder mehr, insbesondere von ca. 2.45 GHz. Anstelle eines Pulses kann auch ein Spreizbandsignal (z. B. PN-Signal) verwendet werden. Ein Pulssignal hat den Vorteil einer einfachen Trennung von Abfrage- und Antwortsignal. Bei PN-Signalen ist die Energie über einen grösseren Zeitbereich gleichmässig verteilt.

Der Transponder erzeugt vorzugsweise ein Antwortsignal mit mehreren Pulsen, die in Zeitfenstern einer Länge von 20-500 ns, insbesondere etwa 100 ns liegen. Der Einfachheit. halber haben alle Zeitfenster die gleiche Länge.

Ein passiver mobiler Transponder zur Durchführung des Verfahrens umfasst eine SAW-Einheit mit mindestens einem Transducer zum Umsetzen eines Abfragesignals in eine Oberflächenwelle und von Oberflächenwellen in ein Antwortsignal und mindestens einen Reflektor zum Reflektieren der vom Transducer ausgesendeten Oberflächenwellen. Gemäss der Erfindung ist der Abstand zwischen Transducer und Reflektor resp. eine Länge des Laufweges resp. Ausbreitungsweges entsprechend einer zu codierenden zeitlichen Verzögerung gewählt. Die Codierung entspricht also der Länge des Weges, den eine vom Transducer abgestrahlte Oberflächenwelle zurücklegen muss, bis sie wieder auf einen Transducer trifft. Auf unterschiedlichen SAW-Einheiten sind im Rahmen der Erfindung unterschiedliche Weglängen realisiert, so dass die Transducer aufgrund der unterschiedlichen Antwortzeiten (resp. Verzögerungszeiten der Signalkomponenten) unterscheidbar sind.

Vorzugsweise sind mehrere Reflektoren vorhanden, die in codespezifischen Abständen zu den Transducern angeordnet sind, um Signalkomponenten in nicht überschneidenden Zeitfenstern zu erzeugen. Es können auch mehrere parallel geschaltete Transducer vorgesehen sein. Die Ausbreitungswege der erzeugten Oberflächenwellen können sich teilweise überlappen oder völlig getrennt sein.

Im Sinne einer ersten Ausführungsvariante sind jedem Transducer genau zwei Reflektoren zugeordnet, wobei der Transducer auf einer geraden Linie zwischen den Reflektoren liegt. Denkbar sind auch asymmetrische Transducer, welche zur Hauptsache nur in einer Richtung abstrahlen.

Gemäss einer besonders bevorzugten Ausführungsform sind mehrere Transducer und Reflektoren in einer. tannenbaumartigen Geometrie angeordnet. Die Reflektoren stehen dabei senkrecht zur Ausbreitungsrichtung der Oberflächenwelle. Jeder Reflektor erzeugt eine eigene Signalkomponente. Bei dieser Ausführungsvariante überlappen die Ausbreitungswege der Oberflächenwellen nicht. Jeder Transducer definiert also einen akustischen Kanal, wobei in jedem solchen Kanal mindestens zwei Reflektoren angeordnet sind.

Besonders vorteilhaft ist es, wenn bei einem Transponder der obengenannten Art die Reflektoren derart orientiert bzw. ausgeführt sind, dass die Oberflächenwellen in Ihrer Ausbreitungsrichtung um einen von 180° verschiedenen Winkel umgelenkt werden. Auf diese Weise kann der Störsignalpegel beträchtlich reduziert werden.

Indem also die Oberflächenwellen quasi auf verwinkelten Pfaden geführt sind, werden Störsignale aufgrund von Doppel- bzw. Mehrfachreflexionen vermieden resp. vom Nutzsignal abgesondert. Während bei den Reflektoranordnungen gemäss US-Patent 4,737,790 zwischen den im selben akustischen Kanal hintereinander angeordneten Reflektoren Mehrfachreflexionen auftreten können, besteht diese Gefahr nicht, wenn die Reflektoren in einem Winkel zur Ausbreitungsrichtung der Oberflächenwellen stehen. Ein weiterer Vorteil besteht darin, dass gewisse unerwünschterweise angeregte Wellen von den Reflektoren nicht in die für das Nutzsignal vorgesehene Richtung umgelenkt werden und damit vom "richtigen" Avsbreitungspfad abkommen. Es leuchtet ein, dass dieser Erfindungsgedanke unabhängig von der weiter oben erwähnten Signaldetektion/-decodierung einsetzbar ist.

Besonders vorteilhaft ist es, wenn die Ausbreitungspfade im wesentlichen U-förmig verlaufen. D. h., die Reflektoren sind so angeordnet bzw. ausgerichtet, dass insgesamt eine Signalumlenkung um 180° erfolgt, ohne dass jedoch der Signalausbreitungspfad auf sich selbst zurückgefaltet wird.

Die Reflektoren können in bezug auf den mindestens einen Transducer so positioniert sein, dass mindestens zwei teilweise überlagerte, jedoch hinsichtlich Länge und/oder Beeinflussung der Oberflächenwelle unterschiedliche Ausbreitungspfade definiert werden. D. h., in einem akustischen Kanal werden zwei oder mehrere Ausbreitungspfade definiert, die allerdings weder auf sich selbst zurückgefaltet noch identisch sind. Die Reflektoren sind dabei vorzugsweise in einem 45°- Winkel zur Achse des Kanals (= Ausbreitungsrichtung) angeordnet (was zu 90°-Reflexionenen führt), wobei zwei spiegelbildlich zueinander ausgerichtete Reflektoren den U-förmigen Ausbreitungspfad erzeugen. Es können auf diese Weise jeweils zwei akustische Kanäle gekoppelt werden. Bei dieser Variante lassen sich nicht nur sehr gute Signal-Rausch-Abstände erzielen, sondern die Chipfläche wird auch sehr gut ausgenutzt.

Alternativ dazu können zu verschiedenen Transducern gehörende, getrennte akustische Kanäle mit Hilfe von mindestens zwei, um 90° umlenkenden und aufeinander ausgerichteten Reflektoren gekoppelt werden. Dies hat zudem den vorteil, dass zwischen den Kanälen im Ausbreitungspfad phasen-und/ oder amplitudenmodulierende Elemente vorgesehen werden können. Vorzugsweise sind dabei auch diese Elemente nicht exakt senkrecht zur Ausbreitungsrichtung der Oberflächenwelle ausgerichtet, sondern weichen von dieser Geometrie geringfügig ab.

Der Winkel alpha zwischen der Ausbreitungsrichtung und der durch das streifenförmige Element definierten Normalen liegt. vorzugsweise zwischen 1° und 10°, insbesondere zwischen 5° und 10°. Dies hat zum Zweck, Störsignale vom Nutzsignal. durch "geometrische Selektion" abzutrennen.

Vorzugsweise sind in mindestens einem akustischen Kanal mehrere teildurchlässige Reflektoren hintereinander angeordnet, wobei der Reflexionsgrad der Reflektoren mit zunehmendem Abstand vom Transducer ansteigt. Die verschiedenen Reflektoren gehören dabei zu teilweise überlappenden aber unterschiedlichen Ausbreitungspfaden. Ziel ist es dabei, die Verluste auf den verschiedenen Ausbreitungspfaden grössenordnungsmässig aufeinander abzustimmen, um allzu starke Pegelunterschiede der Antwortsignalkomponenten des Transponders zu vermeiden.

Die Reflektoren können auf z. B. zwei verschiedene Frequenzen abgestimmt sein (durch geeignete Wahl der Periodizität resp. Abstände der einzelnen Reflektorstreifen voneinander). Auf diese Weise lassen sich leichter teiltransparente Reflektoren realisieren.

Ein besonders guter Abgleich ergibt sich dann, wenn die Reflektivität $R_i$ vom i-ten bis zum i+1-ten Reflektor gemäss folgender Formel zunimmt:

$$R_{i+1} = \frac{R_i}{L * (1 - R_i)}$$

Die Reflektoren werden z. B. durch periodisch angeordnete Metallstreifen gebildet. Um eine möglichst hohe Reflektivität bei möglichst geringer Anzahl Einzelstreifen zu erzielen, eignen sich schwere Metalle wie z. B. Gold oder Platin. Ein einzelner Reflektor sollte in aller Regel weniger als 50, insbesondere höchstens 20 Metallstreifen (Elektrodenfinger) umfassen. Es ist zu beachten, dass die Reflektoren aus identischen, gleichmässig beabstandeten Metallstreifen bestehen, um das Signal teilweise oder ganz zu reflektieren, aber nicht in irgendeiner Art zu verändern (keine Filterfunktion).

Eine weitere Massnahme, um Störsignaleinflüsse resp. unerwünschte Reflexionen zu unterdrücken besteht darin, dass ausserhalb der definierten Ausbreitungswege (der Nutzsignale) Absorber plaziert sind. Sie sollen alle vom definierten Ausbreitungspfad weglaufenden Wellen dämpfen resp. Einkopplungen in den Ausbreitungspfad unterdrükken.

Mit Vorteil wird die SAW-Einheit aus 41- oder 64-LiNbO$_3$ gefertigt. Ein solches Substratmaterial zeigt einen sehr starken piezoelektrischen Effekt, so dass kurze SAW-Pulse schon z. B. mit vier bis zehn Elektrodenpaaren erzeugt und reflektiert werden können. In der Regel kommt man mit 15 oder weniger Elektrodenpaaren aus.

Der kürzeste Ausbreitungsweg entspricht vorzugsweise mindestens der Hälfte des längsten Ausbreitungsweges.

Um Antwortsignale in N Zeitfenstern mit je n Zeitschlitzen zu erzeugen, sind N akustische Kanäle resp. Ausbreitungswege vorgesehen, deren Längen sich im wesentlichen um ganzzahlige Vielfache einer Elementarlänge unterscheiden. Die Elementarlänge entspricht der Wegstrecke, die die Oberflächenwellen innerhalb der Dauer eines Zeitschlitzes zurücklegen. Um welches Vielfache die einzelnen Ausbreitungswege sich unterscheiden, hängt von dem implementierten Code ab und stellt daher ein physisches Unterscheidungskriterium der Transponder dar.

Vorzugsweise sind die Reflektoren durch Metallelektroden aus einem schweren Metall wie z. B. Gold oder Platin gebildet. Dies führt zu einem hohen Reflexionsfaktor der einzelnen Reflektoren. Sollen die Reflektoren dagegen einen Teil der Oberflächenwellen durchlassen, so dass mehrere Reflektoren hintereinander aufgestellt werden können, so soll der Reflexionsgrad ein gewisses Mass natürlich nicht überschreiten. Entsprechend können auch leichtere Metalle (Aluminium etc.) eingesetzt werden.

Mehrere oder alle Transducer können elektrisch miteinander verbunden sein (in Serie- oder Parallelschaltung).

Gemäss einer besonders bevorzugten Ausführungsform haben die Transducer in Kanälen mit grossen Weglängen eine grössere Apertur als diejenigen in Kanälen mit kürzeren Weglängen. Auf diese Weise können die durch die grössere Weglänge bedingten Verluste kompensiert werden.

Da insbesondere bei hohen Frequenzen (z. B. 2.45 GHz) ziemlich grosse Verluste in Kauf genommen (resp. durch entsprechend hohe Signalleistung überwunden) werden müssen, kann die SAW-Einheit mit Schutzschichten (gegen Korrosion) abgedeckt sein, ohne dass die Durchführbarkeit der Signalisierung durch die zusätzlichen Verluste in Frage gestellt wird. Als Schutzschicht eignet sich z. B. SiO$_2$, Photoresist oder Plastikmaterial.

Es versteht sich, dass die erwähnten SAW-Einheiten durch äquivalente Einheiten ersetzt werden können. Zu erwähnen sind die an sich bekannten Anordnungen für die Uebertragung sog. "leaky waves" (gedämpfte wellen, deren Geschwindigkeit grösser als diejenige von gewöhnlichen Oberflächenwellen ist), STW (= surface transversal waves), SSBW (=surface skimming bulk waves).

Eine Uebersicht über die Implementation von SAW-Elementen gibt der eingangs zitierte Artikel "Propagation of acoustic surface waves in periodic structures".

Bei der Herstellung der erfindungsgemässen SAW-Einheiten kann die Generierung von Transducern und die Erzeugung von codierenden Reflektoren in separaten Prozessen erfolgen. Im Unterschied zu bekannten Codiersystemen ist bei der Erfindung kein hochpräzises Plazieren der Reflektoren erforderlich. Bei der Herstellung ist es deshalb möglich, den ganzen Reflektor in einer vorgegegenen Codierungsposition mittels photolithografischer Verfahren zu drucken resp. zu verwirklichen.

Eine Abfragestation zur Durchführung des Verfahrens zeichnet sich durch eine Decodierschaltung zum Diskriminieren der zeitlichen Verzögerungen der Signalkomponenten des Antwortsignals auf der Basis eines vorgegebenen Zeitrasters aus.

Weitere vorteilhafte Ausführungsformen und Merkmalskombinationen ergeben sich aus der Detailbeschreibung und der Gesamtheit der Patentansprüche.

**Kurze Beschreibung der Zeichnungen**

Die zur Erläuterung der Ausführungsbeispiele verwendeten Zeichnungen zeigen:

Fig. 1a, b     Zeitdiagramme zur Erläuterung der erfindungsgemässen Codierung;

Fig. 2     ein grobes Blockschaltbild einer Abfragestation und eines Transponders;

Fig. 3     ein Blockschaltbild eines Transponders;

Fig. 4     eine schematische Darstellung einer SAW-Einheit mit tannenbaumartig angeordneten Reflektoren;

Fig. 5     eine schematische Darstellung eines Layouts einer SAW-Einheit mit $90°$-Reflektoren;

Fig. 6a-c     Prinzipdarstellungen verschiedener Ausführungsvarianten von schrägen Reflektoren;

Fig. 7     Ausführungsbeispiele mit phasenschiebenden bzw. amplitudenmodulierenden Elementen zwischen gekoppelten akustischen Kanälen.

## Wege zur Ausführung der Erfindung

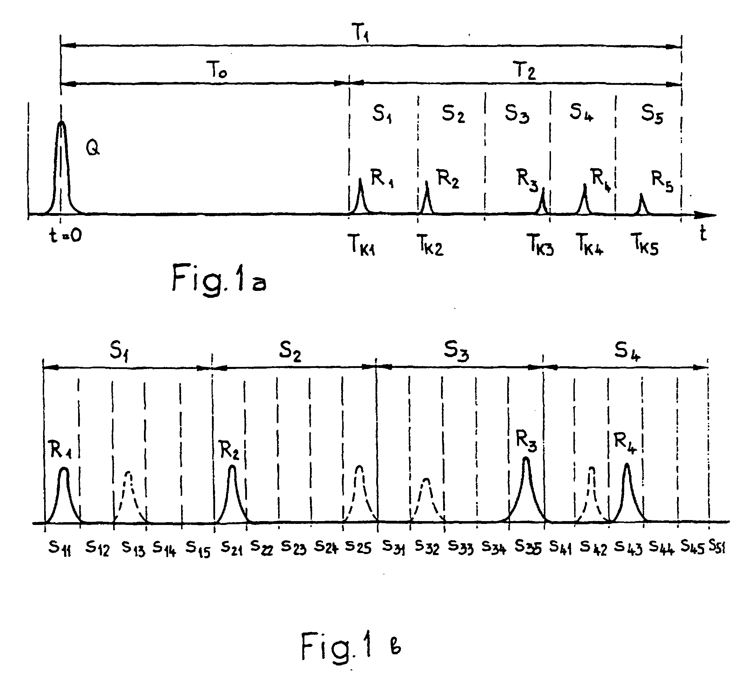

Fig. 1a zeigt schematisch eine mögliche Signalkonstellation (auf der Abszisse ist die Zeit t aufgetragen). Zum Zeitpunkt t = 0 wird ein z. B. pulsförmiges Abfragesignal Q mit einer Trägerfrequenz von z. B. 2.45 GHz ausgesendet. Die Pulsdauer beträgt vorzugsweise weniger als 20 ns (z. B. 5 ns). Ein in Reichweite befindlicher Transponder empfängt das Abfragesig-. nal Q und wandelt es mit Hilfe einer SAW-Einheit in ein Antwortsignal um, das im vorliegenden Beispiel fünf Signalkomponenten $R_1$, ..., $R_5$ aufweist. Die SAW-Einheit ist dabei so gestaltet, dass bis zum Empfang der ersten Signalkomponente $R_1$ ein Zeitintervall $T_0$ verstreicht, das mindestens halb so gross wie das Zeitintervall $T_1$ ist, innerhalb dessen die letzte Signalkomponente $R_5$ eintreffen muss. Wie weiter unten noch zu erläutern sein wird, kann auf diese Weise das Nutzsignal wirkungsvoll von Störsignalen befreit werden.

Das Zeitintervall $T_2 = T_1 - T_0$, dessen Länge für das System (welches in der Regel eine Vielzahl von Transpondern umfasst) fest vorgegeben ist, ist aufgeteilt in eine Vielzahl (im vorliegenden Beispiel fünf) Zeitfenster $S_1$, ..., $S_5$, die alle gleich gross sind (z. B. 100 ns). Alle Transponder des Systems sind so ausgeführt, dass in jedem der fünf Zeitfenster $S_1$, ..., $S_5$ genau eine Signalkomponente $R_1$, ..., $R_5$ auftritt.

Die Länge des Zeitintervalls $T_0$ hängt natürlich nicht nur vom Transponder selbst, sondern auch von seinem Abstand zur Abfragestation ab. Allerdings kann die diesbezüglich bestimmende Abfragedistanz durch geeignetes Festlegen der Mindestund Maximalverzögerung der ersten Antwortsignalkomponente abgegrenzt werden.

Gemäss der Erfindung ist nun die Position einer Signalkomponente $R_1$, ..., $R_5$ innerhalb des entsprechenden Zeitfensters $S_1$, ..., $S_5$ von der im Transponder realisierten Codierung abhängig. Die Abfragestation muss daher zur Identifizierung des Transponders die zeitlichen Positionen $T_{k1}$, ..., $T_{k5}$ des Transponders k bestimmen.

Fig. 1b veranschaulicht die Decodierung des Antwortsignals. Alle Zeitfenster $S_1$, ..., $S_5$ (das letzte Zeitfenster ist in Fig. 1b nicht mehr dargestellt) sind in eine vorgegebene Anzahl von z. B. fünf Zeitschlitzen $s_{11}$, ..., $s_{15}$, $s_{21}$, ..., $s_{25}$, $s_{31}$, ... etc. einer Dauer von z. B. 20 ns aufgeteilt. (Die Länge eines Zeitfensters $S_1$, ..., $S_5$ beträgt in diesem Fall also 100 ns.) Nach dem bekannten Prinzip der matched filter-Technik werden die Signalkomponenten $R_1$, ..., $R_5$ detektiert und dem jeweiligen Zeitschlitz $s_{11}$, $s_{21}$, $s_{35}$, $s_{43}$ zugeordnet. Die Kombination der Zeitpositionen ergibt den transponderspezifischen Code.

In Fig. 1b sind gestrichelt andere mögliche Positionen von Signalkomponenten angedeutet (Zeitschlitze $s_{13}$, $s_{25}$, $s_{32}$, $s_{42}$ etc.). Diese Verteilung der Signalkomponenten würde natürlich zu einem anderen Code führen. Offensichtlich können mit fünf Zeitfenstern zu je fünf Zeitschlitzen $5^5 = 3125$ Codes unterschieden werden. In der Praxis wird man die Zahl der Fenster erhöhen (bei zehn Fenstern zu fünf Schlitzen stehen bereits $5^{10}$ d. h. ca. $10^7$ Codes zur Verfügung). Je kleiner die Breite eines Schlitzes, desto grösser die Anforderungen an die Fertigungsgenauigkeit der SAW-Einheit und desto schwieriger die Detektion. Es ist natürlich nicht erforderlich, dass die Antwortsignalkomponenten vollständig innerhalb eines Zeitschlitzes liegen. Es ist durchaus denkbar, dass sie beidseits aus einem Zeitschlitz herauslappen, wobei jedoch dann zumindest der "Energieschwerpunkt" hinreichend genau lokalisierbar sein muss.

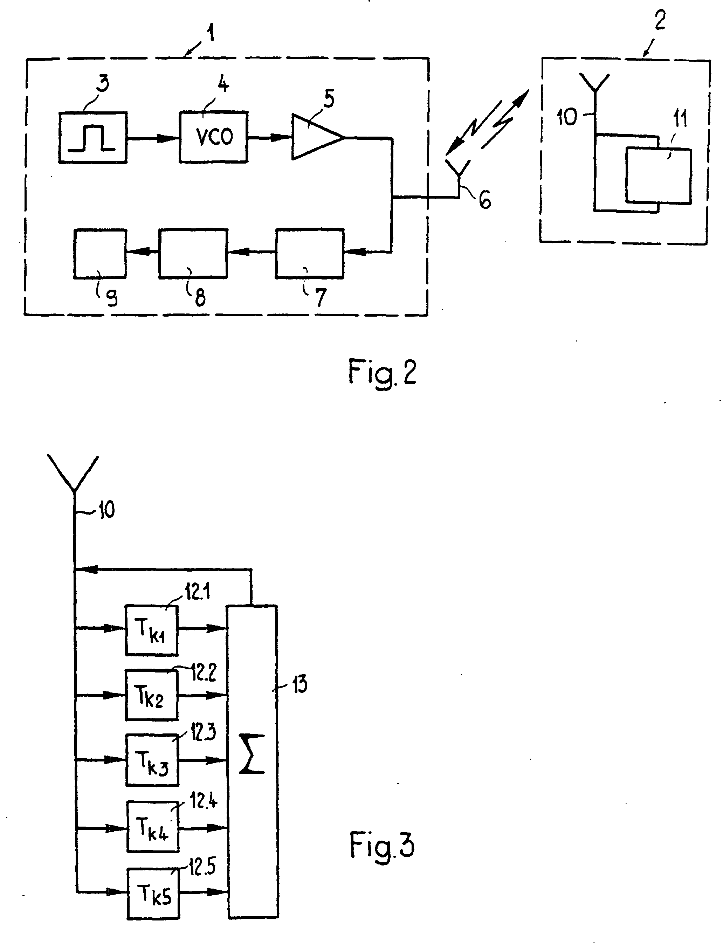

Fig. 2 zeigt ein grobes Blockschaltbild einer Abfragestation 1 und eines Transponders 2. Die z. B. ortsfeste Abfragestation 1 sendet ständig Abfragesignale aus und wertet eintreffende Antwortsignale von mobilen, in der Nähe befindlichen Transpondern aus. Beim Transponder 2 handelt es sich um ein passives Element mit einer Antenne 10 und einer SAW-Einheit 11. Er ist z. B. als flache Scheibe oder Karte ausgebildet und an dem zu identifizierenden Gegenstand als Markierung (Label) angebracht.

Die Abfragestation verfügt über einen Pulsformer 3, welcher geeignet geformte Pulse einer mittleren Dauer von z. B. 5-10 ns erzeugt. Er steuert den Trägersignalgenerator 4 an, welcher ein frequenzstabilisiertes Signal von z. B. 2.45 GHz erzeugt. Das resultierende Abfragesignal wird mit einem Verstärker 5 verstärkt und über eine Antenne 6 abgestrahlt.

Nach Verstreichen des Zeitintervalls $T_0$ (siehe Fig. 1a) trifft das Antwortsignal des Transponders 2 ein. Dieses wird einem Demodulator 7 und dann einer Diskriminator/Decodierschaltung 8 zugeführt. Der Demodulator 7 demoduliert die Signalkomponenten $R_1$, ..., $R_5$ (vgl. Fig. 1a), während die Diskriminator/Decodierschaltung die zeitliche Verzögerung der Signalkomponenten detektiert und entsprechend dem Zeitraster decodiert. Der Code wird z. B. in einem Speicher 9 (welcher z. B. durch einen nicht dargestellten externen Computer lesbar ist) zwischengespeichert.

Fig. 3 veranschaulicht die Funktion des (k-ten) Transponders 2 anhand seines Blockschaltbildes. Das über die Antenne 10 eingekoppelte Abfragesignal wird auf z. B. fünf Signalkanäle 12.1, ..., 12.5 verteilt, die codespezifische Verzögerungen $T_{k1}$, ..., $T_{k5}$ erzeugen. Ein Summierer 13 fasst die Signale der verschiedenen Signalkanäle 12.1, ..., 12.5 zusammen und führt sie wieder der Antenne 10 zu. Wie die nachfolgenden Ausführungen zeigen, können die verschiedenen Signalkanäle 12.1, ..., 12.5 physikalisch vollständig getrennt oder örtlich teilweise überlappend sein. Wichtig ist, dass unterschiedlich lange Ausbreitungswege existieren und deren Länge so bemessen ist, dass Antwortsignalverzögerungen von der in Fig. 1 gezeigten Art erzeugt werden. Weiter ist zu beachten, dass es weder auf Phasenlage noch Amplitude der einzelnen Signalkomponenten im Antwortsignal ankommt. Mit dem Index k soll ferner verdeutlicht werden, dass die Verzögerungen von Transponder zu Transponder anders sind.

Anstelle von pulsförmigen Abfragesignalen können auch sog. chirp-Signale (Signale mit sägezahnförmigem Frequenzverlauf) verwendet werden. Das Antwortsignal besteht dann aus unterschiedlich gegeneinander verschobenen, überlagerten chirp-Signalen. Die Differenzfrequenzen entsprechen den unterschiedlichen Signalverzögerungen. Sie können mit an sich bekannten Filtern extrahiert werden.

Nachfolgend sollen zwei besonders bevorzugte (aber nicht ausschliesslich geeignete) Ausführungen der SAW-Einheit erläutert werden.

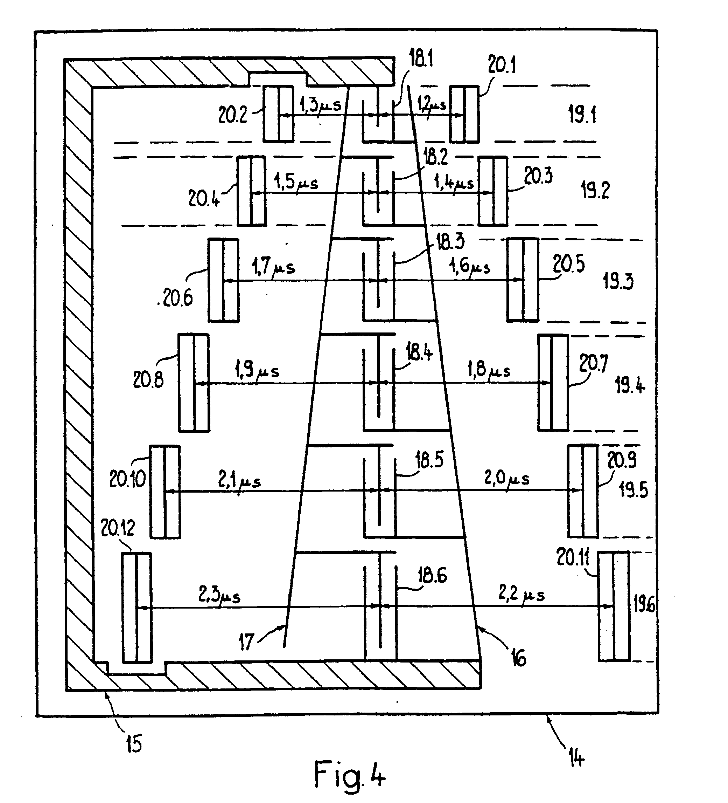

Fig. 4 zeigt ein Substrat 14 z. B. aus Lithiumniobat. Auf ihm ist eine bevorzugte tannenbaumförmige Struktur mit 180°-Reflektoren verwirklicht. (Es können auch Kristallorientierungen resp. -schnitte verwendet werden, die zur Erzeugung bzw. Uebertragung von sog. gedämpften Wellen geeignet sind, wie z. B. 41- oder 64- XY LiNbO$_3$, da die Dämpfung aufgrund der Energieverluste bei 2.45 GHz geringer ist als die Dämpfung aufgrund der Phononen-Wechselwirkungsmechanismen. Für die sog. quasi-shear leaky waves können die Verhältnisse ev. noch besser sein.)

Die tannenbaumförmige Struktur ist zwischen den Enden einer C-förmigen Antennenmetallisierung 15 angeordnet. Auf einer (in Fig. 4 vertikalen) Mittellinie sind sechs elektrisch parallel geschaltete Transducer 18.1, ..., 18.6 vorgesehen. Sie bestehen in an sich bekannter Weise aus ineinandergreifenden Fingerelektroden und sind durch Elektrodenstrukturen 16 resp. 17 mit dem einen resp. anderen Ende der Antennenmetallisierung 15 verbunden. Jeder Transducer 18.1, ..., 18.6 definiert einen (senkrecht zur Mittellinie stehenden akustischen Kanal 19.1, ..., 19.6. Jeder Transducer 18.1, ..., 18.6 ist durch zwei Reflektoren 20.1, 20.2, 20.3, 20.4, ..., 20.12 flankiert.

Gemäss der Erfindung sind die Reflektoren 20.1, ..., 20.12 so positioniert, dass die jeweilige Oberflächenwelle eine codespezifische Laufzeit vom entsprechenden Transducer zum Reflektor und zurück hat. Dabei hat jeder Reflektor 20.1, ..., 20.12 einen anderen Abstand zum jeweiligen Transducer z. B. 18.1 als irgendein anderer Reflektor zu seinem Transducer z. B. 18.2. Zudem sind die Abstände so bemessen, dass in jedes zeitlich vorgegebene Fenster genau eine Laufzeit fällt. Wie erwähnt, ist die Laufzeit innerhalb des Fensters unterschiedlich für die verschiedenen Reflektoren, da sie einen Teil der Codierung bildet.

Im vorliegenden Beispiel ist der Abstand zwischen dem Transducer 18.1 und dem Reflektor 20.1 der kleinste. Er ist so gewählt, dass die Laufzeit der Oberflächenwelle im Bereich von 1.2 µs und 1.3 µs liegt. (Gemäss einer bevorzugten Ausführungsvariante sind z. B. innerhalb des 100 ns-Fensters fünf Positionen möglich. Der Reflektor 20.1 könnte dann z. B. so plaziert sein, dass sich eine Laufzeit von 1.24 µs ergibt.) Der Reflektor 20.2 liegt im Bereich eines 1.3-1.4 µs-Abstands (z. B. in einem 1.32 µs-Abstand) zum Transducer 18.1. Beim Transducer 18.2 liegt der Reflektor 20.3 (welcher benachbart ist zum Reflektor 20.1) in einem Abstand von 1.4-1.5 µs zum Transducer 18.2. Auf der gegenüberliegenden Seite befindet sich der Reflektor 20.4 in einem Abstand von 1.5-1.6 µs zum Transducer 18.2. In diesem Sinn vergrössern sich die Abstände zusehends bis zum untersten Kanal 19.6, in welchem der Reflektor 20.11 den Zeitbereich von 2.2-2.3 µs und der Reflektor 20.12 den Zeitbereich von 2.3-2.4 µs abdeckt. Dies führt hinsichtlich der geometrischen Anordnung der einzelnen Elemente zu einer Tannenbaumstruktur (bei welcher die Transducer 18.1, ..., 18.6 gleichsam den Stamm und die Reflektoren 20.1, ..., 20.12 gleichsam die Aeste des Tannenbaums bilden).

Weiter ist in Fig. 4 gezeigt, dass sich die Apertur der Kanäle 19.1, ..., 19.6 von den kleinen Laufzeiten im Bereich von 1.2-1.4 µs (Kanal 19.1) zu den grösseren Laufzeiten von 2.2-2.4 µs (Kanal 19.6) zunehmend vergrössert. Da einerseits in den Kanälen mit geringer Apertur von den Transducern weniger akustische Energie abgestrahlt wird als in den Kanälen mit grosser Apertur, die zunehmende Länge des Ausbreitungsweges andererseits jedoch zu wachsenden Verlusten führt, hat dies zur Folge, dass im Endeffekt die Signalkomponenten des abgestrahlten Antwortsignals energiemässig in der gleichen Grössenordnung liegen.

Die in Fig. 4 vereinfacht dargestellten Transducer 18.1, ..., 18.6 umfassen z. B. zehn Elektrodenfinger. Aehnliches gilt für die Reflektoren 20.1, ..., 20.12, die z. B. 10 bis 15 Elektrodenpaare aufweisen. Werden die Elektroden aus einem Metall mit hohem spezifischem Gewicht (z. B. Gold oder Platin) hergestellt, reichen für eine gute Reflektivität bereits weniger Elektrodenpaare aus.

Indem der kleinste Abstand (1.2-1.3 µs) mindestens halb so gross wie der grösste Abstand (2.3-2.4 µs) ist, sind parasitäre Störsignale aufgrund von Doppelreflexionen (sog. round trip-Signale: Transducer 18.1 - Reflektor 20.1 - Reflektor 20.2 - Transducer 18.1) zeitlich von den Nutzsignalen getrennt (d. h. die parasitären Signale folgen erst nach der letzten Nutzsignalkomponente). Ein weiterer Vorteil des gezeigten Ausführungsbeispiels besteht darin, dass die Ausbreitungswege vollständig getrennt sind. Im Unterschied zum Stand der Technik gemäss US-4,737,790 gibt es keine teiltransparenten Reflektoren, welche von gewissen Signalen durchquert werden müssen, von anderen aber nicht.

Die wichtigsten Verzögerungsverschiebungen sind diejenigen, die durch Temperaturveränderungen bedingt sind. Beim vorliegenden Beispiel (Substrat aus 64-LiNbO$_3$) betragen die genannten Verzögerungsverschiebungen zwischen erster und letzter Antwortsignalkomponente ±4 ns. Im Vergleich dazu sind die Alterungseffekte (schätzungsweise bei ±0.1 ns) und die Geschwindigkeitsunterschiede zwischen den einzelnen Wafern (±0.1 ns) vernachlässigbar klein. Dies zeigt, dass das erfindungsgemässe System sozusagen keine Kalibration erfordert.

Das Verhältnis der Apertur der Kanäle liegt im vorliegenden Beispiel bei $W_{i+1} : W_i$ = 1.175 (die Apertur $W_{i+1}$ ist dem Kanal mit grösserer Verzögerung zugeordnet als die Apertur $W_i$). Mit zunehmendem Abstand Transducer zu Reflektor nimmt die Apertur also um nahezu 20% zu.

Eine Abschätzung der Verluste zeigt folgendes:

| Kanal | relative Apertur | propagation loss in dB | mismatch loss in dB | Summe der beiden Verluste in dB |
|-------|------------------|------------------------|---------------------|----------------------------------|
| 19.1 | 1 | 8.4 | 26.3 | 34.7 |
| 19.2 | 1.175 | 9.8 | 24.9 | 34.7 |
| 19.3 | 1.38 | 11.2 | 23.5 | 34.7 |
| 19.4 | 1.622 | 12.6 | 22.1 | 34.7 |
| 19.5 | 1.906 | 14.0 | 20.7 | 34.7 |
| 19.6 | 2.24 | 15.6 | 19.2 | 34.8 |

Für 64-LiNbO$_3$ und eine Elektrodengeometrieaufteilung entsprechend der dritten Harmonischen ergibt sich eine Gesamtimpedanz in der Grössenordnung von 50 Ohm, wenn die kleinste Apertur im Bereich von 50 lambda (Wellenlänge der Oberflächenwelle) liegt. Die Verluste insgesamt liegen bei schätzungsweise 43 dB (einschliesslich Reflektivitäts-, Widerstands- und Streuungsverluste).

Wird im vorliegenden Beispiel der brauchbare Verzögerungsbereich (vgl. Zeitintervall T$_2$ in Fig. 1a) von 1.1 µs in elf 100 ns-Intervalle und jedes davon in fünf 20 ns-Zeitschlitze unterteilt, dann beträgt die Länge einer sog. Codierposition (= Zeitschlitz) auf 64-LiNbO$_3$ etwas mehr als 47 µm. Die Reflektoren sind also möglichst in der Mitte des entsprechenden Codierbereiches zu positionieren. Sie haben eine tatsächliche Länge von z. B. 15 µm. Dies zeigt, dass die Positionierung eines Reflektors innerhalb des Codierbereiches kein kritischer Parameter ist und ohne weiteres mit einer (für konventionelle photolithografische Prozesse üblichen) Genauigkeit von ±2 µm erfolgen kann. Daher ist es fertigungstechnisch ohne weiteres möglich, alle Reflektoren in einem Schritt (d. h. als Ganzes) zu drucken.

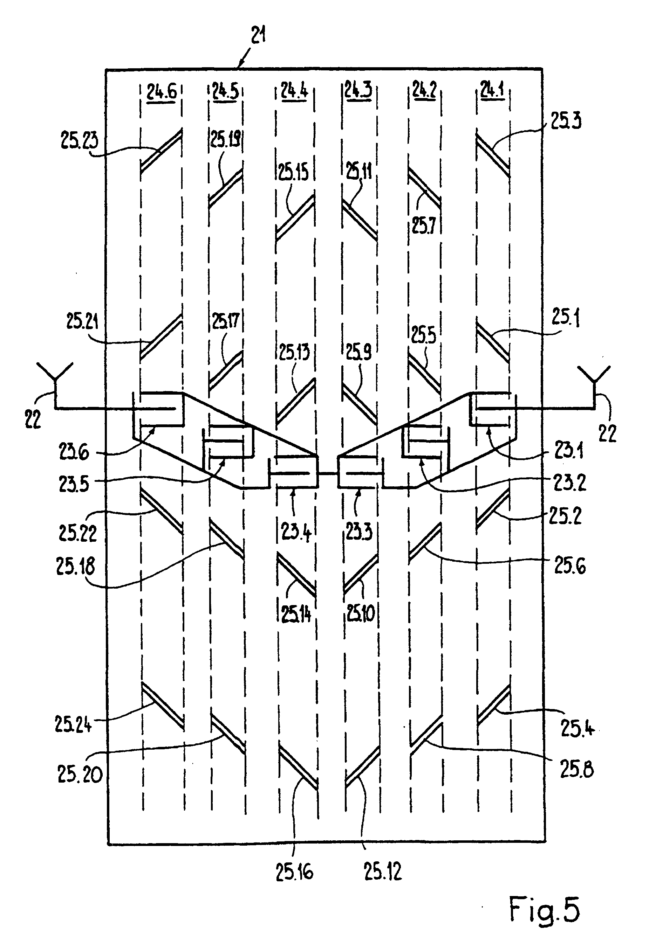

Fig. 5 zeigt ein zweites bevorzugtes Ausführungsbeispiel eines Chip-Layouts für eine SAW-Einheit. Der wesentliche Unterschied zur Variante gemäss Fig. 4 besteht in der Verwendung von 90°-Reflektoren.

Auf einer Mittelachse eines Substrats 21 sind sechs Transducer 23.1, ..., 23.6 angeordnet. Gemäss einer bevorzugten Ausführungsform sind sie jedoch nicht streng auf der genannten Mittellinie, sondern auf zwei zueinander im Winkel stehenden Linien positioniert. Dies führt zu einer V-förmigen Struktur. Die Transducer 23.1, ..., 23.6 sind in an sich bekannter Weise mit einer Antenne 22 verbunden.

Die sechs Transducer 23.1, ..., 23.6 definieren sechs parallele akustische Kanäle 24.1, ..., 24.6. In jedem akustischen Kanal 24.1, ..., 24.6 sind vier Reflektoren 25.1, ..., 25.4 resp. 25.5, ..., 25.8 resp. ... 25.21, ..., 25.24 angeordnet. Sie stehen jeweils unter einem 45°-winkel zu einer Oberflächenwellenausbreitungsrichtung im jeweiligen Kanal 24.1, ..., 24.6. Im vorliegenden Beispiel sind die Reflektoren 25.1, ..., 25.24 so ausgerichtet, dass stets zwei bezüglich der Längsmittelachse spiegelbildlich angeordnete Kanäle 24.1 und 24.6 resp. 24.2 und 24.5 resp. 24.3 und 24.4 miteinander gekoppelt werden.

Die vom Transducer 23.1 ausgehenden Oberflächenwellen werden teilweise von den beiden näherliegenden Reflektoren 25.1, 25.2 und im übrigen von den weiter entfernt liegenden Reflektoren 25.3, 25.4 um 90° abgelenkt, von den Reflektoren 25.21, 25.22 resp. 25.23, 25.24 aufgefangen und zum Transducer 23.6 gelenkt. Es versteht sich, dass die innenliegenden Reflektoren 25.1, 25.2, ..., 25.21, 25.22 teildurchlässig sein müssen.

Gemäss der Erfindung sind die Längen der U-förmigen Ausbreitungswege je unterschiedlich so festgelegt, dass sie in zwölf verschiedenen, nicht überlappenden Fenstern entsprechend der gewünschten Codierung liegen.

Auf weitere Einzelheiten (Anzahl Elektroden pro Reflektor, Apertur etc.) soll an dieser Stelle nicht weiter eingegangen werden. Sie ergeben sich in sinngemässer Anwendung der Erläuterungen zu Fig. 4. Zu beachten ist, dass die Störungen. aufgrund von Mehrfachreflexionen (sog. round trip-Signale) sehr viel kleiner sind als bei Ausführungsformen mit 180°-Reflektoren (Fig. 4). Weiter ist zu beachten, dass die Chip-Oberfläche besser als beim Stand der Technik ausgenutzt werden kann. Insbesondere können die Chips mit günstigeren Seitenverhältnissen (quadratnahe Seitenverhältnisse) realisiert werden als bei der Verwendung von 180°-Reflektoren.

Fig. 6a-c zeigt schematisch verschiedene geometrische Ausführungen der Erfindung.

Gemäss Fig. 6a ist ein einziger Transducer 31.1 vorgesehen, der einen akustischen Kanal 33.1 vorgibt. Im akustischen Kanal 33.1 sind zwei Reflektoren 32.1, 32.2 positioniert, welche einen U-förmigen Ausbreitungspfad 34.1 für die Oberflächenwellen erzeugen.

Die beiden Reflektoren 32.1, 32.2 werden je durch eine bestimmte Anzahl von gleichmässig beabstandeten, parallelen Metallstreifen bzw. Elektrodenfingern gebildet und zwar so, dass möglichst die gesamte auftreffende Oberflächenwelle reflektiert wird. Die Reflektoren 32.1, 32.2 stehen jeweils im 45°- Winkel zu einer Kanallängsachse (bzw. Ausbreitungsrichtung der vom Transducer 31.1 erzeugten Oberflächenwellen). Sie haben den gleichen Abstand vom Transducer 31.1 und stehen spiegelsymmetrisch zueinander. Sie nehmen jeweils weniger als die halbe Breite des akustischen Kanals in Anspruch.

In Fig. 6a sind dem Transducer 31.1 nur gerade zwei Reflektoren 32.1, 32.2 zugeordnet. Um die abgestrahlte akustische Energie möglichst optimal nutzen zu können, sollte entweder der Transducer 31.1 im wesentlichen nur einseitig abstrahlen, oder es sollte ein zweites Paar von Reflektoren auf der gegenüberliegenden Seite vorgesehen sein.

Einseitig resp. asymmetrisch abstrahlende Elektrodenstrukturen sind im Prinzip bekannt.

Fig. 6b zeigt eine Variante mit zwei getrennten Transducern 31.2, 31.3. Sie definieren zwei getrennte akustische Kanäle 33.2, 33.3. In jedem der beiden akustischen Kanäle 33.2, 33.3 sind beidseits des Transducers 31.2 resp. 31.3 Reflektoren 32.3, 32.5 resp. 32.4, und 32.6 vorgesehen. Wird der Transducer 31.2 durch ein elektrisches Signal erregt, dann erzeugt er in diametral entgegengesetzten Richtungen weglaufende Oberflächenwellen, welche von den Reflektoren 32.3 resp. 32.5 um 90° umgelenkt und von den Reflektoren 32.4, resp. 32.6 aufgefangen und ebenfalls um nochmals 90° umgelenkt werden, um schliesslich wieder zum Transducer 31.3 zu gelangen. Es sind dadurch zwei U-förmige Ausbreitungspfade 34.2, 34.3 definiert. Die in den beiden Kanälen 33.2 und 33.3 angeordneten Transducer 31.2 resp. 31.3 und Reflektoren 32.3, 32.5 resp. 32.4, 32.6 sind im wesentlichen spiegelbildlich zueinander.

Zu beachten ist, dass die Ausbreitungspfade 34.2 und 34.3 unterschiedliche Längen haben. Die unterschiedlichen Längen führen zu unterschiedlichen Signallaufzeiten und können als Transpondercodierung detektiert werden. Wie das weiter unten erläuterte Ausführungsbeispiel zeigen wird, können durch Kombinieren einer Vielzahl von Signalausbreitungspfaden nahezu beliebige Informationscodes verwirklicht werden.

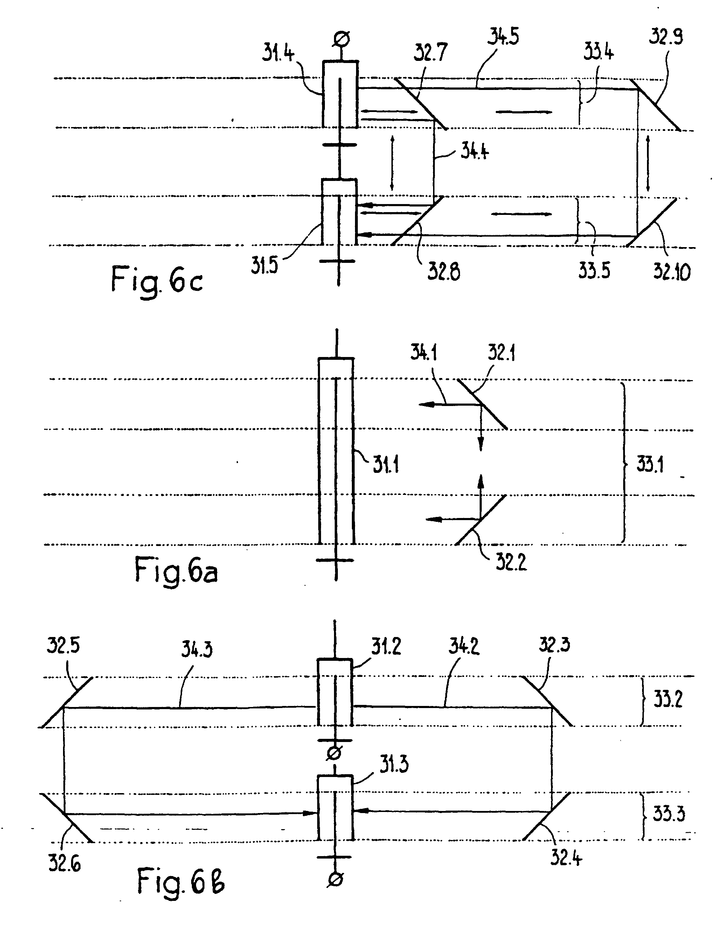

Fig. 6c zeigt eine einfache Ausführungsvariante mit teiltransparenten Reflektoren. Zwei (im vorliegenden Fall elektrisch in Serie geschaltete) Transducer 31.4, 31.5 definieren zwei beabstandete akustische Kanäle 33.4 resp. 33.5. In jedem der genannten Kanäle 33.4, 33.5 sind hintereinander zwei Reflektoren 32.7, 32.9, resp. 32.8, 32.10 plaziert. Mit den beiden Reflektoren 32.7 und 32.8 wird ein erster Ausbreitungspfad 34.4 und mit den Reflektoren 32.9, 32.10 ein zweiter Ausbreitungspfad 34.5 definiert.

Gemäss einer bevorzugten Ausführungsform sind die Ausbreitungspfade 34.4, 34.5 teilweise überlagert. Wie aus der Fig. 6c zu erkennen ist, sind die Ueberlagerungen durch die Streckenabschnitte zwischen den Transducern 31.4 resp. 31.5 und den näherliegenden Reflektoren 32.7 resp. 32.8 gebildet.

Es leuchtet ein, dass namentlich die in Fig. 6c gezeigte Ausführungsvariante eine sehr gute Nutzung der benötigten Fläche ermöglicht. Anders als bei 180°- Reflektoren ist es zudem möglich, von den aus dem Stand der Technik bekannten sehr langen und schmalen SAW-Chips zu kürzeren dafür breiteren (sog. quadratnahen) überzugehen. Dies hat herstellungstechnisch den vorteil, dass der durch lokale Substratdefekte bedingte Ausschuss reduziert werden kann.

Bei der Variante gemäss Fig. 6c können die inneren Reflektoren 32.7, 32.8 auf eine leicht andere Frequenz abgestimmt werden als die äusseren Reflektoren 32.9, 32.10. Dies dient zur Verwirklichung einer Teiltransparenz. Die Transducer 31.4, 31.5 müssen natürlich beide Frequenzen generieren resp. absorbieren können. Der Frequenzunterschied sollte daher weniger als 5 %, vorzugsweise etwa 1-2 % der Signalfrequenz betragen. Bei einer Signalfrequenz von 2,45 GHz würde sich die Differenzfrequenz im Bereich von ca. 100 MHz bewegen. Der Transducer kommt dann mit ca. 50 Elektrodenfingern (oder sogar weniger) aus.

Die in den Fig. 6a-c gezeigten Varianten lassen sich natürlich in vielfältiger Weise modifizieren, erweitern und kombinieren. Dies gilt insbesondere für die Merkmale "einseitige/zweiseitige Abstrahlung", "teilüberlagerte/getrennte Ausbreitungspfade".

Zu erwähnen ist weiter, dass die geometrischen Anordnungen der Fig. 6a-c abgewandelt werden können. So brauchen die Transducer nicht auf einer gemeinsamen Mittellinie plaziert zu werden (siehe dazu Fig. 5). Anstelle von 45°- Reflektoren können z. B. je ein 30°- und ein 60°- Reflektor vorgesehen sein. Denkbar ist weiter, dass die akustischen Kanäle nicht zu mehrfach gekoppelten Paaren (wie in Fig. 6c), sondern zu einem kettenartig gekoppelten Verbund ("Serienschaltung") vereinigt werden.

Bei piezoelektrischen Substraten stehen für die Signalausbreitung nur ausgewählte Richtungen zur Verfügung. Welche Richtungen auf welchen Substraten und für welche Wellentypen möglich ist, ergibt sich z. B. aus dem eingangs zitierten Artikel von Guljaev und Plesskii.

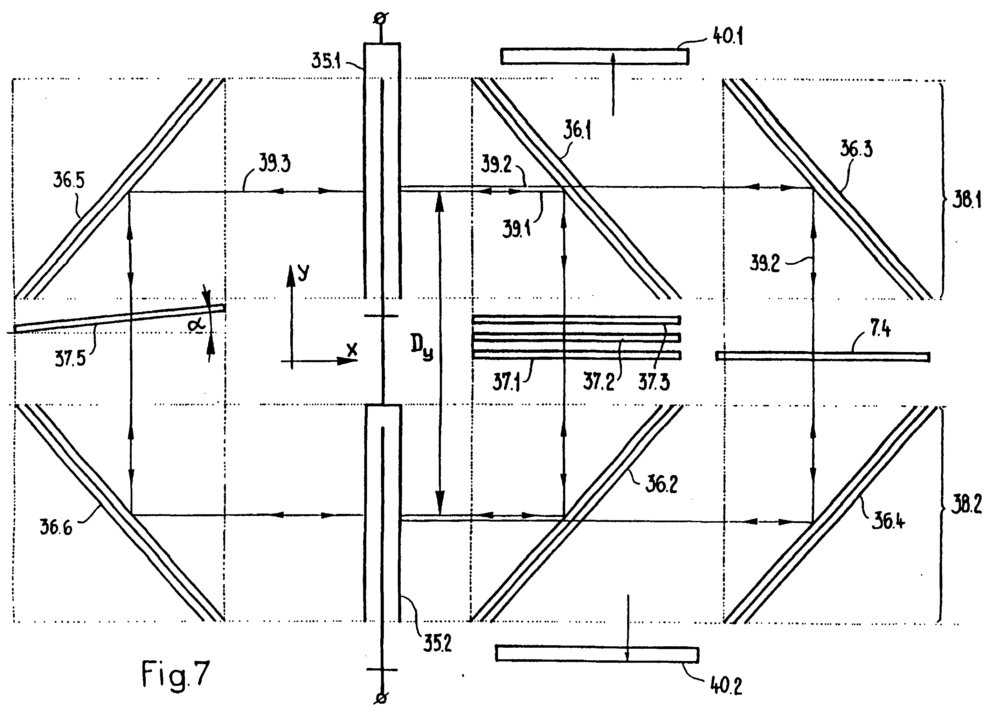

Aufgrund der fallweise definierten Ausbreitungsrichtungen, die natürlich die zulässigen Orientierungen der akustischen Kanäle vorgeben, wird in vielen Fällen die Parallelität der akustischen Kanäle und möglicherweise auch die Winkelorientierung der Reflektoren als unabänderbar zu betrachten sein. In jedem Fall ist es nun aber möglich, den Abstand der akustischen Kanäle nach Belieben festzulegen. Dies eröffnet Möglichkeiten zur Modulation der Oberflächenwelle, wie im folgenden anhand der Fig. 7 zu erläutern sein wird.

Eingezeichnet sind zwei Transducer 35.1, 35.2, deren akustische Kanäle einen Mittenabstand Dy haben. Dieser kann unter Berücksichtigung der Abstände der Reflektoren 36.1, ..., 36.6 von den Transducern 35.1, 35.2 in gewünschter Weise festgelegt werden. Es ist klar, dass durch Verändern des Abstandes Dy die Laufzeitunterschiede der Ausbreitungspfade 39.1, ..., 39.3 nicht geändert werden.

Zwischen den Kanälen 38.1, 38.2 können nun gemäss einer bevorzugten Ausführungsform Phasenschieberelemente 37.1, ..., 37.5 angeordnet sein, um die auf verschiedenen Ausbreitungspfaden 39.1, ..., 39.3 laufenden Oberflächenwellen in gezielt unterschiedlicher Weise phasenmässig zu modulieren. Es kann dabei sichergestellt werden, dass jedes Phasenschieberelement (37.1 bis 37.3 resp. 37.4 resp. 37.5) nur auf einem ganz bestimmten Ausbreitungspfad wirkt. Dies erleichtert das Chipdesign beträchtlich.

Um Störsignale zu eliminieren, können die streifenförmigen Phasenschieberelemente, z. B. 37.5, um einen kleinen Winkel alpha von z. B. 5-10° aus der "Normalposition" (in welcher die Normalrichtung des streifenförmigen Phasenschieberelements parallel zur lokalen Richtung des Ausbreitungspfades steht - vgl. Phasenschieberelemente 37.1, ..., 37.4) herausgedreht sein.

Um aus dem Signalweg ausgekoppelte Störsignale unschädlich zu machen, sind z. B. seitlich neben den Reflektoren 36.1, 36.2 Absorber 40.1, 40.2 plaziert. Geeignet sind Strukturen, die die Störwellenenergie zerstreuen resp. vernichten. Selbstverständlich können solche Absorber auch an anderen kritischen Stellen vorgesehen sein.

Eine Amplitudenmodulation lässt sich z. B. dadurch erreichen, dass ein Phasenschieberelement sich z. B. nur über die halbe Apertur des Ausbreitungspfades erstreckt und eine Phasenschiebung von 180° bewirkt. Die nachfolgende Ueberlagerung der beiden "nebeneinanderlaufenden" Teilwellen führt in diesem Fall zu einer (vollständigen oder partiellen) Signalauslöschung, mithin zu einer Amplitudenmodulation.

Aus den bisherigen Erläuterungen ergibt sich, dass im Rahmen der Erfindung zwei klar unterscheidbare Arten der Transpondercodierung möglich sind:

1. Eine Codierung der Laufzeiten (durch geeignete Positionierung der Reflektoren) und

2. eine Codierung durch Einfügen von Phasenschieber- bzw. Amplitudenmodulationselementen.

Selbstverständlich steht auch die Kombination dieser beiden Codierungsarten zur Verfügung.

Im folgenden werden ein paar konkrete Ausführungsbeispiele zur Verdeutlichung der obigen Erläuterungen angeführt.

Die erfindungsgemässen Transponder eignen sich z. B. für ein mit kurzen Abfragepulsen (von z. B. 12 ns) arbeitendes Abtast- und Identifikationsverfahren. Auf einem YZ-LiNbO3-Substrat werden z. B. IDT-Strukturen (IDT Interdigital Transducer) vorgesehen, welche in jedem (akustischen) Kanal z. B. 10 Fingerelektrodenpaare aufweisen mit einer Apertur von 120 lambda (lambda = Wellenlänge der Oberflächenwelle). Dies ergibt eine Strahlungsimpedanz von 50 Ω bei zwei in Serie geschalteten Transducern.

Vorzugsweise wird eine Anfangsverzögerung von etwa 1 μs implementiert, indem der Mittenabstand Dy zwischen den akustischen Kanälen entsprechend festgelegt wird (z. B. auf 3,75 mm). Diese Anfangsverzögerung hat bei einer Arbeitsfrequenz von ungefähr 2,5 GHz einen Dämpfungsverlust von etwa 7,5 dB zur Folge. Ein grosser Wert für den Abstand Dy ist im übrigen durchaus von Vorteil, da die Plazierung der Phasenschieberelemente erleichtert wird. Die ganze Breite des SAW-Chips beträgt etwa 4 mm, die Gesamtlänge etwa 8-10 mm.

Bei einem sog. multi-channel-tag (bei welchem die SAW- Einheit mehrere akustische Kanäle aufweist) wird die elektromagnetisch übertragene Energie des Abfragesignals auf z. B. 16 Kanäle aufgeteilt. Die verwendeten Reflektoren zeichnen sich durch eine möglichst hohe Reflektivität aus (was dadurch erreicht werden kann, dass die Elektrodenfinger aus einem schweren Metall hergestellt sind). Wenn man annimmt, dass die Laufzeitunterschiede zwischen den verschiedenen Signalkanälen (Ausbreitungspfade) durchschnittlich etwa 100 ns betragen, dann hat der letzte Antwortpuls gegenüber dem ersten eine Verzögerung von etwa 1,5 μs und erleidet dadurch (bei einer Arbeitsfrequenz von ungefähr 2,5 GHz) eine Abschwächung von 11 dB. Der letzte Antwortpuls ist also etwa 11 dB schwächer als der erste. Diese Abschwächung ist angesichts eines Gesamtverlusts von 42,5 dB verkraftbar.

Ein weiteres Beispiel stellt ein sog. one-channel-tag dar. Für ein YZ LiNb03- Substrat liegen die Reflexionskoeffizienten (von Z nach X) für einen einzelnen Streifen bei etwa 2 %. Bei N = 10 Streifen beträgt der Amplitudenreflexionskoeffizient des ganzen 90°- Reflektors etwa 0.2. Eine Reflexion an zwei solchen Reflektoren führt auf einen Reflexionskoeffizient von 0.04. D. h., etwa 96 % der Energie der Oberflächenwelle geht durch den Reflektor hindurch. Bei einer Signalfrequenz von $f_0$ = 2,45 GHz ergibt sich ein Passband von der Grösse 2 x $f_0$ : N = 490 MHz und eine Dauer der Stossantwort von etwa 4 ns. Der reflektierte Puls ist grob gesagt 12 + 4 = 16 ns lang.

Das letzte Echosignal muss durch 2 x 7 Reflektoren hindurch. Sein Energieverlust beträgt $0.96^{14}$ = 0.56 (= 2.5 dB). Dazu kommt ein Reflexionskoeffizient von $0.04^2$.

Nimmt man wie beim vorgängig angeführten Beispiel eine Verzögerungzeit des letzten Echos gegenüber dem ersten von 1,5 µs an, dann müssen noch etwa 11 dB Ausbreitungsverluste hinzugerechnet werden. Der Energieverlust des letzten Pulses ist somit 2.5 dB + 11 dB = 13.5 dB höher als derjenige des ersten Pulses. Somit ist der Gesamtverlust des letzten Pulses etwa 6 + 20 x |log (0.04)| + 7.5 + 11 + 2.5 = 55 dB. Führt man dieselbe Berechnung für 20 Elektrodenfinger für jeden Reflektor durch, so ergibt sich ein Gesamtverlust von etwa 51 dB, allerdings auf Kosten einer höheren Ungleichförmigkeit der Amplitude im Bereich von 17 dB.

Die obigen Berechnungen zeigen, dass der sog. multi-channel-tag hinsichtlich der Verluste vorteilhafter als der one-channel-tag ist, vorausgesetzt, die Dämpfungsverluste (attenution loss) sind vernachlässigbar.

Um die Situation zu verbessern, können die Reflektivitäten von einem Reflektor zum nächsten progressiv erhöht werden. vorzugsweise werden die Reflexionskoeffizienten $R_i$ in Abhängigkeit vom Reflexionskoeffizient des vorgelagerten (und von der Oberflächenwelle teilweise zu durchdringenden) Reflektors unter Berücksichtigung der folgenden Gleichung festgelegt:

$$R_{i+1} = \frac{R_i}{L * (1 - R_i)}$$

wobei L den Dämpfungskoeffizienten zwischen benachbarten Reflektoren bezeichnet. Im weiter oben angeführten Beispiel entspricht L der im Verlauf einer Ausbreitungszeit von 100 ns erlittenen Dämpfung: $L \approx 0.84$ ( 0.75 dB / 100 ns).

In diesem Fall können die Reflexionskoeffizienten und die Zahl der Elektrodenfinger wie folgt festgelegt werden (in der ersten Spalte sind die Reflektoren durchnummeriert, beginnend bei dem am nächsten zum Transducer liegenden):

| Positionsnummer des Reflektors | R (Energie) | Anzahl Elektrodenfinger |
|---|---|---|
| 1 | 0.05 | 11 |
| 2 | 0.063 | 12 |
| 3 | 0.08 | 14 |
| 4 | 0.103 | 16 |
| 5 | 0.137 | 18 |
| 6 | 0.188 | 22 |
| 7 | 0.276 | 26 |
| 8 | 0.454 | 34 |

Werden die Reflektoren in dieser Weise ausgebildet, dann liegen die Gesamtverluste in der Grössenordnung von 32 dB + 7.5 dB = 39.5 dB (wobei in der Praxis noch etwa 5 dB dazukommen dürften).

Die Verwendung von 90°- Reflektoren zeichnet sich zusammenfassend durch folgende Vorteile aus:

1. Parasitäre Mehrfachreflexionen fehlen praktisch vollständig. Einige unerwünschte reflektierte Wellen werden durch die Reflektoren nach aussen weggestreut und erreichen die Transducer nicht. Dies ist eine Eigenschaft von fischgratartigen Verzögerungslinien. Auch sog. bulkwaves können die Transducer nicht erreichen. Dies im Unterschied zur In-line-Geometrie gemäss US 4,737,790.

2. Aufgrund der geringen Störsignalanteile können ohne weiteres 16 Reflektoren in einem Kanal angeordnet werden. Die SAW-Einheit kann auf diese Weise in der Querabmessung etwa 4 x kleiner gemacht werden als beim zitierten Stand der Technik.

3. Der Transducer kann dabei leicht an die erforderliche Impedanz angepasst werden, wobei keine Energieverluste aufgrund der Aufteilung auf verschiedene Kanäle in Kauf genommen werden müssen.

4. Die Stärke des Reflektors kann geeignet festgelegt resp. gewichtet werden, ohne dass die Gefahr erhöhter parasitären Signale auftritt.

5. Bei den erfindungsgemäss um 45° geneigten Reflektoren ist die Breite eines einzelnen Elektrodenelements etwa 1,4 Mal grösser als beim 180°- Reflektor. Dies ist deshalb sehr vorteilhaft, weil die Breite dadurch von etwa 0,4 µm auf bessere 0,57 µm zunimmt. (Herstellungsgenauigkeit geringer.)

6. Die Reproduzierbarkeit nimmt aufgrund der geringen Anzahl von Transducern (und des entsprechend geringen Flächenbedarfs) zu. (Die Wahrscheinlichkeit für Defekte ist im wesentlichen proportional zur Fläche des Elektrodensystems.)

7. Ein wichtiger Aspekt ist schliesslich, dass die einzelnen Finger der Reflektoren an den Enden nicht kurzgeschlossen werden müssen (sie sind sogenannt "self-shorted"). Die Kurzschlusskontakte würden zusätzliche Widerstände und Verluste einführen.

Wenn auch die Ausführungsbeispiele durchgehend 90°- Reflektionen zeigen, beschränkt sich die Erfindung nicht auf diesen Winkelwert. Durch geeignete Wahl des piezoelektrischen Substrats, dessen Kristallorientierung bzw. - schliffs können auch kleinere oder grössere Umlenkwinkel realisiert werden.

Zusammenfassend ist festzustellen, dass ein erfindungsgemässer SAW-Chip leichter und kostengünstiger herzustellen ist und sich für Abfragesysteme unterschiedlicher Codierungsarten einsetzen lässt.

Selbstverständlich beschränkt sich die Erfindung nicht auf die gezeigten Ausführungsbeispiele. So ist es z. B. nicht zwingend, dass die Reflektoren in regelmässigen Anordnungen (z. B. geraden Linien oder V-Linien) aufgebaut werden. Die Abfolge der Verzögerungszeiten kann im Prinzip beliebig festgelegt werden. Bei einer Abwandlung der Variante gemäss Fig. 5 ist natürlich darauf zu achten, dass sich die Reflektoren von verschiedenen Kanälen nicht in unerwünschter Weise überlappen.

Soweit im Zusammenhang mit der Erfindung von Oberflächenwellen gesprochen wird, soll dies nicht nur die "klassischen" Oberflächenwellen betreffen, sondern auch die sog. leaky waves, die surface transverse waves (STW) die surface skimming bulk waves (SSBW) und ähnliche. Diese Wellen sind als solche bekannt. Zu deren Generierung sind jeweils spezifische Kristallorientierungen resp. Kristallschliffe und Elektrodenanordnungen bzw. -ausrichtungen vorzusehen. In diesem Zusammenhang wird auf den Artikel "Propagation of acoustic surface waves in periodic structures", Yu.V. Gulyaev, V.P. Plesskii, Sov. Phys. Usp. 32(1), January 1989, resp. American Institute of Physics, 1989, S. 51-74 verwiesen.

Um die Elektroden der SAW-Einheiten vor Verschmutzung und Korrosion zu schützen, kann die Substratoberfläche mit einer dielektrischen Schicht (wie z. B. $SiO_2$, Photoresist, Plastikmaterial etc.) abgedeckt werden. Die dadurch bedingte Dämpfung der Oberflächenwellen ist in der Regel unkritisch, wenn mit Substraten mit starken piezoelektrischen Effekten gearbeitet wird.

Zum Auslesen des Codes der SAW-Einheit eignet sich jedes Signalisierungsverfahren, das die Laufzeitunterschiede, sei es direkt oder via Differenzfrequenzen auflösen kann.

Zusammenfassend ist festzuhalten, dass durch die Erfindung ein Verfahren und Mittel zur Durchführung des Verfahrens geschaffen worden sind, die eine reduzierte Empfindlichkeit gegenüber Störungen, Temperatureinflüssen und Fertigungsungenauigkeiten aufweisen.

**Patentansprüche**

1.  Verfahren zum berührungslosen Identifizieren von passiven mobilen Transpondem, wobei eineAbfragestation (1) ein moderliertes Abfragesignal (Q) in Form einen Pulses oder Spreizbandsignals aussendet, der Transponder (2) das Abfragesignal (Q) entsprechend einem für ihn spezifischen Code in ein Antwortsignal mit mehreren codespezifisch verzögerten Signalkomponenten (R1, ..., R5) umwandelt und die Abfragestation (1) das zurückgesendete Antwortsignal decodiert,
    **dadurch gekennzeichnet, dass**
    der Code in spezifisch definierten Zeit-Positionen (Tk1, ..., Tk5) der genannten mehreren Signalkomponenten (R1, ..., R5) im Antwortsignal liegt, derart dass
    in jedes von mehreren aufeinanderfolgenden, nicht überfappenden Zeitfenstem (S1, ..., S5) genau eine Signalkomponente (R1, ..., R5) zu liegen kommt und innerhalb des jeweiligen Zeitfensters (S1, ..., S5), welches jeweils in eine vorgegebene Anzahl von Zeitschlitzen (s11, ..., s15; s21, ..., s25; ...) aufgeteilt wird, eine dem Code entsprechende Position einnimmt,
    so dass eine Decodierung des Antwortsignals durch Zuordnen der Signalkomponenten (R1, ..., R5) zu einem Zeitschlitz (s11, s21, s35, s43) erfolgen kann,

wobei der kleinste für die Codierung verwendete Unterschied der Zeit-Positionen (Tk1, ..., Tk5) zu einer laufzeitverzögerung der entsprechenden Signalkomponenten führt, welche grösser ist als die Periodendauer der Trägerfrequenz des Abfrage signals.

2. Verfahren nach Anspruch 1, wobei die Positionen (Tk1, ..., Tk5) der Signalkomponenten (R1, ..., R5) im Antwortsignal durch die Laufzeiten umterschiedlich Langer Ausbreitungswege auf dem Transponder bestimmt sind.

3. Verfahren nach Anspruch 1 oder 2, wobei die Zahl der Signalkomponenten (R1, ..., R5) für alle Transponder eines Systems gleich ist.

4. Verfahren nach Anspruch 1, 2 oder 3, wobei die der ersten Position (Tk1) entsprechende zeitliche Verzögerung der ersten Signalkomponente (R1) mindestens die Hälfte der zeitlichen Verzögerung (T1) der letzten Signalkomponente (R5) beträgt.

5. Passiver Transponder (2) zur Durchführung des Verfahrens nach einem der Ansprüche 1 bis 4, umfassend eine SAW-Einheit mit mindestens einem Transducer (18.1, ..., 18.6; 23.1, ..., 23.6) zum Umsetzen eines elektromagnetischen Abfragesignals in Oberflächenwellen und umgekehrt und mindestens einem Reflektor (20.1, ..., 20.12; 25.1, ..., 25.24) zum Umlenken der Oberflächenwellen, **dadurch gekennzeichnet, dass**
Transducer (18.1, ..., 18.6; 23.1, ..., 23.6) und Reflektor(en) (20.1, ..., 20.12; 25.1, ..., 25.24) so positioniert sind.
dass Ausbreitungswege für die Oberflächenwellen definiert sind, deren unterschiedliche Laufzeiten dem zu erzeugenden Code entsprechen, derart dass
in jedes von mehreren aufeinanderfolgenden, nicht überlappenden Zeitfenstern (S1, ..., S5) genau eine codespezifisch verzögerte Signalkomponente (R1, ..., R5) zu liegen kommt und innerhalb des jeweiligen Zeitfensters (S1, ..., S5), welches jeweils in eine vorgegebene Anzahl von Zeitschlitzen (s11, ..., s15: s21, ..., s25; ...) aufgeteilt wird, eine dem Code entsprechende Position einnimmt,
so dass eine Decodierung des Antwortsignals durch Zuordnen der Signalkomponenten (R1, ..., R5) zu einem Zeitschlitz (s11, s21, s35, s43) erfolgen kann,
wobei der kleinste für die Codierung verwendete Unterschied der Zeit-Positionen (Tk1, ..., Tk5) zu einer Laufzeitverzögerung der entsprechenden Signalkomponenten führt, welche grösser ist als die Periodendauer der Trägerfrequenz des Abfragesignals.

6. Transponder nach Anspruch 5, wobei die Zahl der Signalkomponenten (R1, ..., R5) für alle Transponder eines Systems gleich ist.

7. Transponder nach Anspruch 5 oder 6 wobei in jedem Kanal (19.1, ..., 19.6) genau zwei Reflektoren (20.1, 20.2; 20.3. 20.4; ...) vorgesehen sind, die Laufzeiten von Kanal zu Kanal (19.1, ..., 19.5) grösser werden und Transducer (18.1, ..., 18.6) und Reflektoren (20.1, ..., 20.12) eine tannenbaumartige Geometrie bilden.

8. Passiver Transponder insbesondere nach Anspruch 5, 6 oder 7 mit einer SAW-Einheit zur Erzeugung von Antwortsignalen enthaltend einen identifizierbaren Code, wobei die SAW-Einheit mindestens einen Transducer (23.1, ..., 23.6) zum Umwandeln elektrischer Signale in Oberflächenwellen und umgekehrt sowie mehrere Reflektoren (25.1, ..., 25.24) aufweist, **dadurch gekennzeichnet, dass** die Reflektoren (25.1, ..., 25.24) derart orientiert bzw. ausgeführt sind, dass die Oberflächenwellen in einem von 180° verschiedenen Winkel umgelenkt werden.

9. Passiver Transponder nach Anspruch 8, wobei die Reflektoren (32.1, .... 32.10) derart orientiert bzw. ausgeführt sind, dass die Oberflächenwellen auf U-förmig vertaufenden Ausbreitungspfaden (34.1, ..., 34.5) geführt sind.

10. Passiver Transponder nach einem der Ansprüche 8 oder 9, wobei die Reflektoren (32.7, ..., 32.10) in bezug auf den mindestens einen Transducer (31.4, 31.5) so positioniert sind, dass mindestens zwei teilweise überlagerte, aber unterschiedliche Ausbreitungspfade (34.4, 34.5) gebildet sind.

11. Passiver Transponder nach einem der Ansprüche 8 bis 10, wobei in einem durch den mindestens einen Transducer (31.1) definierten Kanal (33.1) zwei im 45° Winkel zu einer Hauptrichtung des Kanals (33.1) ausgerichtete, miteinander korrespondierende Reflektoren (32.1, 32.2) vorgesehen sind zur Bildung eines U-förmigen Ausbreitungspfades (34.1).

12. Passiver Transponder nach einem der Ansprüche 8 bis 11, wobei zwischen den Kanälen (38.1, 38.2) im Ausbreitungpfad (39.1, 39.2, 39.3) angeordnete Elemente (37.1, ..., 37.5) zum Verändem der Phase und/oder Amplitude der Oberflächenwellen vorgesehen sind, die genannten Elemente (37.1, ..., 37.5) mit ihrer Normalrichtung um einen Winkel gegenüber der Ausbreitungsrichtung der Oberflächenwellen abweichen und dieser Winkel zwischen 1 und 10°, insbesondere zwischen 5°und 10° liegt.

**13.** Passiver Transponder nach einem der Ansprüche 8 bis 12, wobei in mindestens einem Kanal (33.4, 33.5) mehrere Reflektoren (32.7, 32.9 resp. 32.8, 32.10) hintereinander angeordnet sind, wobei die Reflektoren (32.7, ..., 32.10) teildurchlässig sind und Reflexionskoeffizienten aufweisen, die mit zunehmendem Abstand vom entsprechenden Transducer (31.4, 31.5) ansteigen.

**14.** Transponder nach einem der Ansprüche 5 bis 13, wobei Kanäle mit grossen Weglängen eine grössere Apertur haben als Kanäle mit kürzeren Weglängen.

**15.** Transponder nach einem der Ansprüche 5 bis 14, wobei die SAW-Einheit eine dielektrische Schutzschicht, insbesondere aus $SiO_2$, Photoresist oder Plastikmaterial aufweist.

**16.** Abfragestation zur Durchführung des Verfahrens nach einem der Ansprüche 1 bis 4, **gekennzeichnet durch** eine Decodierschaltung (8) zum Diskriminieren der Zeit-Positionen (Tk1, ..., Tk5) der codespezifisch verzögerten Signalkomponenten (R1, ..., R5) im Antwortsignal entsprechend einem vorgegebenen Zeitraster (S1, ..., S5; s11, ...), wobei der Code in spezifisch definierten Zeit-Positionen (Tk1, ..., Tk5) der genannten mehreren Signalkomponenten (R1, ..., R5) im Antwortsignal liegt, derart dass
in jedes von mehreren aufeinanderfolgenden, nicht überlappenden Zeitfenstem (S1, ..., S5) genau eine Signalkomponente (R1, ..., R5) zu liegen kommt und innerhalb des jeweiligen Zeitfensters (S1, ..., S5), welches jeweils in eine vorgegebene Anzahl von Zeitschlitzen (s11, ..., s15; s21, ..., s25; ...) aufgeteilt wird. eine dem Code entsprechende Position einnimmt.
so dass eine Decodierung des Antwortsignals **durch** Zuordnen der Signalkomponenten (R1, ..., R5) zu einem Zeitschlitz (s11, s21, s35, s43) erfolgen kann,
wobei der kleinste für die Codierung verwendete Unterschied der Zeit-Positionen (Tk1, ..., Tk5) zu einer Laufzeitverzögerung der entsprechenden Signalkomponenten führt, welche grösser ist als die Periodendauer der Trägerfrequenz des Abfragesignals.

**17.** Abfragestation nach Anspruch 16, wobei die Zahl der Signalkomponenten (R1, ..., R5) für alle Transponder eines Systems gleich ist.

**18.** Anlage zur Durchführung des Verfahrens nach einem der Ansprüche 1 bis 4 mit mehreren passiven mobilen Transpondern nach einem der Ansprüche 5 bis 15 und mindestens einer Abfragestation nach Anspruch 16 oder 17, **dadurch gekennzeichnet, dass** unterschiedliche Transponder so ausgebildet sind, dass sie voneinander hinsichtlich der Zeit-Positionen verschiedene Antwortsignale erzeugen, um eine Identifikation aufgrund der in der jeweiligen Zeit-Position des Antwortsignals enthaltenen Codierung zu ermöglichen.

**Claims**

**1.** A passive mobile transponder remote identification process, wherein an interrogation station (1) sends out a modulated interrogation signal (Q) in the form of a pulse or spread band signal,
the transponder (2) converts, in accordance with a code being specific to it, the interrogation signal (Q) into a response signal having a plurality of code-specifically delayed signal components (R1, ..., R5), and
the interrogation station (1) decodes the returned response signal,
**characterized in that**
the code lies within specifically defined time positions (Tk1, ..., Tk5) of said plurality of signal components (R1, ..., R5) in the response signal, such that
exactly one signal component (R1, ..., R5) comes to rest in any one of the plurality of subsequent, non-overlapping time windows (S1, ..., S5) and takes a position corresponding to the code within the respective time window (S1, ..., S5) which is divided in a predetermined number of time slots (s11, ..., s15; s21, ..., s25; ...),
so that the response signal can be decoded by allocating the signal components (R1, ..., R5) to a time slot (s11, s21, s35, s43),
wherein the smallest difference in the time positions (Tk1, ..., Tk5) used for encoding results in a propagation delay of the corresponding signal components which is greater than the period length of the carrier frequency of the interrogation signal.

2. The process according to claim 1, wherein the positions (Tk1, ..., Tk5) of the signal components (R1, ..., R5) in the response signal are determined by the propagation times of propagation paths of different length on the transponder.

3. The method according to claim 1 or 2, wherein the number of signal components (R1, ..., R5) is the same for all transponders of a system.

4. The method according to claim 1, 2 or 3, wherein the time delay of the first signal component (R1), which corresponds to the first position (Tk1), is at least half of the time delay (T1) of the last signal component (R5).

5. A passive transponder (2) for carrying out the method according to any one of claims 1 to 4, comprising an SAW unit having at least one transducer (18.1, ..., 18.6; 23.1, ..., 23.6) for converting an electromagnetic interrogation signal into surface waves and vice-versa and at least one reflector (20.1, ..., 20.12; 25.1, ..., 25.24) for deflecting the surface waves, **characterized in that**
the transducer(s) (18.1, ..., 18.6; 23.1, ..., 23.6) and reflector(s) (20.1, ..., 20.12; 25.1, ..., 25.24) are positioned such that propagation paths, whose different propagation times correspond to the code to be generated, are defined for the surface waves, such that
exactly one code-specifically delayed signal component (R1, ..., R5) comes to rest in any one of the plurality of subsequent, non-overlapping time windows (S1, ..., S5) and takes a position corresponding to the code within the respective time window (S1, ..., S5) which is divided in a predetermined number of time slots (s11, ..., s15; s21, ..., s25; ...),
so that the response signal can be decoded by allocating the signal components (R1, ..., R5) to a time slot (s11, s21, s35, s43),
wherein the smallest difference in the time positions (Tk1, ..., Tk5) used for encoding results in a propagation delay of the corresponding signal components which is greater than the period length of the carrier frequency of the interrogation signal.

6. The transponder according to claim 5, wherein the number of signal components (R1, ..., R5) is the same for all transponders of a system.

7. The transponder according to claim 5 or 6, wherein exactly two reflectors (20.1, 20.2, 20.3, 20.4, ...) are provided in each channel (19.1, ..., 19.6), the propagation periods become larger from channel to channel (19.1, ..., 19.5) and the transducer (18.1, ..., 18.6) and reflectors (20.1, ..., 20.12) form a geometry having the shape of a Christmas tree.

8. A passive transponder, in particular according to claim 5, 6 or 7, comprising an SAW unit for generating response signals containing an identifiable code, wherein the SAW unit comprises at least one transducer (23.1, ..., 23.6) for converting electric signals into surface waves and vice versa as well as a plurality of reflectors (25.1, ..., 25.24), **characterized in that** the reflectors (25.1, ..., 25.24) are oriented or configured such that the surface waves are deflected in an angle different from 180°.

9. The passive transponder according to claim 8, wherein the reflectors (32.1, ..., 32.10) are oriented or configured such that the surface waves are guided on U-shaped propagation paths (34.1, ..., 34.5).

10. The passive transponder according to any one of claims 8 or 9, wherein the reflectors (32.7, ..., 32.10) are positioned with respect to the at least one transducer (31.4, 31.5) such that at least two partially overlapping but different propagation paths (34.4, 34.5) are formed.

11. The passive transponder according to any one of claims 8 to 10, wherein two reflectors (32.1, 32.2), which are aligned at an angle of 45° with respect to a main direction of the channel (33.1) and which correspond with one another, are arranged in a channel (33.1) defined by the at least one transducer (31.1) in order to form a U-shaped propagation path (34.1).

12. The passive transponder according to any one of claims 8 to 11, wherein elements (37.1, ..., 37.5) for changing the phase and/or amplitude of the surface waves are provided between the channels (38.1, 38.2) in the propagation path (39.1, 39.2, 39.3), said elements (37.1, ..., 37.5) in their normal direction deviate by an angle vis-à-vis the propagation direction of the surface waves, and this angle lies between 1° and 10°, in particular between 5° and 10°.

**13.** The passive transponder according to any one of claims 8 to 12, wherein a plurality of reflectors (32.7, 32.9, or 32.8, 32.10) are arranged one behind the other in at least one channel (33.4, 33.5), wherein the reflectors (32.7, ..., 32.10) are partially permeable and comprise reflection coefficients which increase with increasing distance from the corresponding transducer (31.4, 31.5).

**14.** The transponder according to any one of claims 5 to 13, wherein channels having long propagation paths have a larger aperture than channels having shorter propagation paths.

**15.** The transponder according to any one of claims 5 to 14, wherein the SAW unit comprises a dielectric protective layer, in particular of $SiO_2$, photoresist or a plastic material.

**16.** An interrogation station for carrying out the process according to any one of claims 1 to 4, **characterized by** a decoding circuit (8) for discriminating the time positions (Tk1, ..., Tk5) of the code-specifically delayed signal components (R1, ..., R5) in the response signal corresponding to a predetermined time frame (S1, ..., S5; s11, ...), wherein the code lies in specifically defined time positions (Tk1, ..., Tk5) of said plurality of signal components (R1, ..., R5) in the response signal, such that
exactly one signal component (R1, ..., R5) comes to rest in any one of the plurality of subsequent, non-overlapping time windows (S1, ..., S5) and takes a position corresponding to the code within the respective time window (S1, ..., S5) which is divided in a predetermined number of time slots (s11, ..., s15; s21, ..., s25; ...),
so that the response signal can be decoded by allocating the signal components (R1, ..., R5) to a time slot (s11, s21, s35, s43),
wherein the smallest difference in the time positions (Tk1, ..., Tk5) used for encoding results in a propagation delay of the corresponding signal components which is greater than the period length of the carrier frequency of the interrogation signal.

**17.** The interrogation station according to claim 16, wherein the number of signal components (R1, ..., R5) is the same for all transponders of a system.

**18.** Arrangement for carrying out the process according to any one of claims 1 to 4 comprising a plurality of passive mobile transponders according to any one of claims 5 to 15 and at least one interrogation station according to claim 16 or 17, **characterized in that** different transponders are configured such that they generate response signals which are different from each other as regards the time positions in order to allow an identification on the basis of the encoding contained in the corresponding time position of the response signal.

## Revendications

**1.** Procédé d'identification à distance de répondeurs mobiles passifs dans lequel une station d'interrogation (1) envoie un signal d'interrogation modélisé (Q) en forme d'impulsion ou de signal à étalement de spectre :

le répondeur (2) convertit le signal d'interrogation (Q) conformément à un code qui lui est spécifique en un signal de réponse avec plusieurs composantes de signal (R1, ..., R5) retardées spécifiquement au code et la station d'interrogation (1) décode le signal de réponse renvoyé,

**caractérisé en ce que**
le code se trouve dans des positions temporelles définies spécifiquement (Tk1, ..., Tk5) de plusieurs composantes de signal citées (R1, ..., R5) dans un signal de réponse, de telle manière que
dans chaque fenêtre temporelle de plusieurs fenêtres temporelles (S1, ..., S5) successives, ne se chevauchant pas, vient se placer exactement une composante de signal (R1, ..., R5) et à l'intérieur de la fenêtre temporelle respective (S1, ..., S5), laquelle est à chaque fois divisée en un nombre prédéfini de créneaux temporels (s11, ..., s15 ; s21, ..., s25 ; ...) , prend une position correspondant au code,
de sorte qu'un décodage du signal de réponse peut avoir lieu par attribution des composantes de signal (R1, ..., R5) à un créneau temporel (s11, s21, s35, s43),
la plus petite différence utilisée pour le codage des positions temporelles (Tk1, ..., Tk5) conduisant à un retard de la durée de fonctionnement des composantes de signal correspondantes qui est plus grande que la durée de période de la fréquence porteuse du signal d'interrogation.

**2.** Procédé selon la revendication 1, dans lequel les positions (Tk1, ..., Tk5) des composantes de signal (R1, ..., R5)

**EP 0 791 180 B1**

dans le signal de réponse sont déterminées par les durées de fonctionnement de trajets de propagation différemment longs sur le répondeur.

3. Procédé selon la revendication 1 ou 2, dans lequel le nombre des composantes de signal (R1, ..., R5) est égal pour tous les répondeurs d'un système.

4. Procédé selon la revendication 1, 2 ou 3, dans lequel le retard temporel correspondant à la première position (Tk1) des premières composantes de signal (R1) s'élève au moins à la moitié du retard temporel (T1) des dernières composantes de signal (R5).

5. Répondeur passif (2) destiné à exécuter le procédé selon l'une des revendications 1 à 4, comprenant une unité à ondes acoustiques de surface avec au moins un transducteur (18.1, ..., 18.6 ; 23.1, ..., 23.6) pour convertir un signal d'interrogation électromagnétique en ondes de surface et inversement et au moins un réflecteur (20.1, ..., 20.12 ; 25.1, ..., 25.24) pour dévier les ondes de surface, **caractérisé en ce que**
le(s) transducteur (s)(18.1, ..., 18.6 ; 23.1, ..., 23.6) et le(s) réflecteur(s) (20.1, ..., 20.12 ; 25.1, ..., 25.24) sont positionnés de manière telle que des trajets de propagation sont définis pour les ondes de surface, dont les différents temps de fonctionnement correspondent au code à produire, de telle manière que dans chaque fenêtre temporelle de plusieurs fenêtres temporelles (S1, ..., S5) successives, ne se chevauchant pas, vient se placer exactement une composante de signal (R1, ..., R5) retardée spécifiquement au code et est divisée à l'intérieur de la fenêtre temporelle respective (S1, ..., S5), laquelle est divisée à chaque fois en un nombre prédéfini de créneaux temporels (s11, ..., s15 ; s21, ..., s25 ; ...) , prend une position correspondant au code,
si bien qu'un décodage du signal de réponse peut avoir lieu par attribution des composantes de signal (R1, ..., R5) à un créneau temporel (s11, s21, s35, s43), la plus petite différence de positions temporelles (Tk1, ..., Tk5) utilisée pour le codage conduisant à un retard de la durée de fonctionnement des composantes de signal correspondantes, laquelle est plus grande que la durée de période de la fréquence porteuse du signal d'interrogation.

6. Répondeur selon la revendication 5, dans lequel le nombre des composantes de signal (R1, ..., R5) est égal pour tous les répondeurs d'un système.

7. Répondeur selon la revendication 5 ou 6, dans lequel dans chaque canal (19.1, ..., 19.6) sont prévus exactement deux réflecteurs (20.1, 20.2 ; 20.3, 20.4 ; ...), les durées de fonctionnement de canal à canal (19.1, ..., 19.5) sont plus grandes et le répondeur (18.1, ..., 18.6) et les réflecteurs (20.1, ..., 20.12) forment une géométrie de type en forme de sapin.

8. Répondeur passif notamment selon la revendication 5, 6 ou 7 avec une unité à ondes acoustiques de surface pour produire des signaux de réponse renfermant un code identifiable, l'unité à ondes acoustiques de surface présentant au moins un transducteur (23.1, ..., 23.6) pour convertir des signaux électriques en ondes de surface et inversement ainsi que plusieurs réflecteurs (25.1, ..., 25.24), **caractérisé en ce que** les réflecteurs (25.1, ..., 25.24) sont orientés resp. réalisés de telle manière que les ondes de surface sont renvoyées selon un angle différent de 180°.

9. Répondeur passif selon la revendication 8, dans lequel les réflecteurs (32.1, ..., 32.10) sont orientés resp. réalisés de telle manière que les ondes de surface sont guidées sur des trajets de propagation passant en forme de U (34.1, ..., 34.5).

10. Répondeur passif selon l'une des revendications 8 ou 9, dans lequel les réflecteurs (32.7, ..., 32.10) sont positionnés par rapport à au moins un transducteur (31.4, 31.5) de telle manière que au moins deux trajets de propagation (34.4, 34.5) superposés mais différents sont formés.

11. Répondeur passif selon l'une des revendications 8 à 10, dans lequel dans un canal (33.1) défini par le au moins un transducteur (31.1) sont prévus deux réflecteurs (32.1, 32.2) correspondant ensemble, orientés selon un angle de 45° par rapport à une direction principale du canal (33.1), pour former un trajet de propagation (34.1) en forme de U.

12. Répondeur passif selon l'une des revendications 8 à 11, dans lequel sont prévus des éléments (37.1, ..., 37.5) disposés entre les canaux (38.1, 38.2) dans le trajet de propagation (39.1, 39.2, 39.3) afin de modifier la phase et/ou l'amplitude des ondes de surface,
les éléments cités (37.1, ..., 37.5) avec leur sens normal s'écartent en angle par rapport au sens de propa-

**17**

gation des ondes de surface et cet angle se situe entre 1 et 10°, en particulier entre 5 et 10°.

**13.** Répondeur passif selon l'une des revendications 8 à 12, dans lequel dans au moins un canal (33.4, 33.5) plusieurs réflecteurs (32.7, 32.9 resp. 32.8, 32.10) sont disposés les uns derrière les autres, les réflecteurs (32.7, ..., 32.10) étant semi-transparents et présentent des coefficients de réflexion qui augmentent avec un intervalle croissant du transducteur correspondant (31.4, 31.5).

**14.** Répondeur selon l'une des revendications 5 à 13, dans lequel des canaux avec de grandes longueurs de trajet ont une ouverture plus grande que des canaux avec des longueurs de trajet plus courtes.

**15.** Répondeur selon l'une des revendications 5 à 14, dans lequel l'unité à ondes acoustiques de surface présente une couche protectrice diélectrique, notamment en $SiO_2$, résine photosensible ou matière plastique.

**16.** Station d'interrogation pour exécuter le procédé selon l'une des revendications 1 à 4, **caractérisée par** un circuit de décodage (8) pour différencier les positions temporelles (Tk1, ..., Tk5) des composantes de signal retardées spécifiquement au code (R1, ..., R5) dans un signal de réponse correspondant à un quadrillage temporel prédéfini (S1, ..., S5 ; s11, ...) , le code se trouvant dans des positions temporelles définies spécifiquement (Tk1, ..., Tk5) de plusieurs composantes de signal citées (R1, ..., R5) dans un signal de réponse, de telle manière que dans chaque fenêtre temporelle de plusieurs fenêtres temporelles (S1, ..., S5) successives, ne se chevauchant pas, vient se placer exactement une composante de signal (R1, ..., R5) et à l'intérieur de la fenêtre temporelle respective (S1, ..., S5), laquelle est à chaque fois divisée en un nombre prédéfini de créneaux temporels (s11, ..., s15 ; s21, ..., s25 ; ...), prend une position correspondant au code,
si bien qu'un décodage du signal de réponse peut avoir lieu par attribution des composantes de signal (R1, ..., R5) à un créneau temporel (s11, s21, s35, s43), auquel cas la plus petite différence utilisée pour le codage des positions temporelles (Tk1, ..., Tk5) conduit à un retard de la durée de fonctionnement des composantes de signal correspondantes, laquelle est plus grande que la durée de période de la fréquence porteuse du signal d'interrogation.

**17.** Station d'interrogation selon la revendication 16, dans laquelle le nombre de composantes de signal (R1, ..., R5) est égal pour tous les répondeurs d'un système.

**18.** Installation pour exécuter le procédé selon l'une des revendications 1 à 4 avec plusieurs répondeurs mobiles passifs selon l'une des revendications 5 à 15 et au moins une station d'interrogation selon la revendication 16 ou 17, **caractérisée en ce que** différents répondeurs sont conçus de manière telle qu'ils produisent des signaux de réponse différents les uns des autres en ce qui concerne les positions temporelles, pour rendre possible une identification sur la base du codage contenu dans les positions temporelles respectives du signal de réponse.

Fig. 1a

Fig. 1 b

Fig. 2

Fig. 3

Fig. 4

Fig.5

Fig. 6c

31.4    ⌀    32.7    34.5    33.4    32.9

34.4

31.5    32.8    33.5    32.10

Fig. 6a

34.1    32.1

31.1    33.1

32.2

32.5    34.3    31.2    34.2    32.3

33.2

31.3

33.3

32.6    Fig. 6ß    32.4

Fig.7